# EUROPEAN PATENT SPECIFICATION

(11) **EP 4 496 013 B1**
(45) Date of publication and mention of the grant of the patent: **22.10.2025**
(21) Application number: 23220473.5
(22) Date of filing: 28.12.2023
(51) Int. Cl.: H10H 20/813, H10H 20/84, H10H 20/821

(54) **LIGHT-EMITTING DEVICE AND METHOD OF MANUFACTURING THE SAME**
LICHTEMITTIERENDE VORRICHTUNG UND VERFAHREN ZU IHRER HERSTELLUNG
DISPOSITIF ÉLECTROLUMINESCENT ET SON PROCÉDÉ DE FABRICATION

(30) Priority: 17.07.2023 KR 20230092470
(43) Date of publication of application: 22.01.2025
(73) Proprietor: Samsung Electronics Co., Ltd., Suwon-si, Gyeonggi-do 16677 (KR)
(72) Inventor: SHIN, Dongchul, 16678 Suwon-si (KR); KIM, Joosung, 16678 Suwon-si (KR); PARK, Junghun, 16678 Suwon-si (KR)
(74) Representative: Elkington and Fife LLP

(56) References cited:
- US-A1- 2012 217 474
- US-A1- 2016 254 138
- US-A1- 2018 211 829
- US-A1- 2020 313 042

## Description

### FIELD OF THE INVENTION

This disclosure relates to a light-emitting device and a method of manufacturing the same.

### BACKGROUND OF THE INVENTION

Light-emitting devices (LEDs) are high-efficiency and eco-friendly light sources that are used in various fields, such as displays, optical communications, automobiles, and general lighting. Recently, semiconductor light-emitting devices and manufacturing technologies thereof using nanostructures have been proposed to increase light efficiency through improved crystallinity and increased emission area. Semiconductor light-emitting devices using nanostructures generate relatively little heat, and the surface area of a light-emitting portion is increased by the nanostructures and thus relatively high luminous efficiency may be obtained. Each of the documents US 2018/211829 A1, US 11049997 B2, US 016/254138 A1, US 2012/217474 A1, describe a rod shaped semiconductor device formed on substrate comprising an upper semiconductor body portion which is wider than a lower portion of the elongated semiconductor body.

### SUMMARY OF THE INVENTION

Provided are a light-emitting device that may suppress a decrease in luminous efficiency due to polarization phenomenon and a method of manufacturing the light-emitting device.

Further, provided are a light-emitting device with an increased emission area and a method of manufacturing the light-emitting device.

Additional aspects will be set forth in part in the description which follows and, in part, will be apparent from the description, or may be learned by practice of the presented embodiments of the disclosure.

According to an aspect of the disclosure, a light-emitting device may include a base semiconductor layer, at least one core provided on the base semiconductor layer, the at least one core including a body portion extending in a first direction and a shielding portion provided at an upper end of the body portion, where a width of a lower surface of the shielding portion in a second direction orthogonal to the first direction is greater than a width of the body portion in the second direction, a first insulating layer provided on an upper surface of the base semiconductor layer and an upper surface of the shielding portion, and at least one light-emitting portion provided on a side surface of the body portion.

The width of the shielding portion in the second direction may gradually decrease from the lower surface of the shielding portion toward an upper end of the shielding portion in the first direction.

The side surface of the body portion may be a non-polar plane.

The side surface of the body portion may include a first portion adjacent to the base semiconductor layer and a second portion above the first portion in the first direction, the light-emitting device may include a second insulating layer provided on the first portion of the side surface of the body portion that is adjacent to the base semiconductor layer, the at least one light-emitting portion may be provided on the second portion of the side surface of the body portion that is above the first portion of the side surface of the body portion and the second insulating layer may not be formed on the second portion of the side surface of the body portion.

The base semiconductor layer may include a material that is the same as a material of the at least one core.

The at least one light-emitting portion may include a first conductivity type semiconductor layer provided on the side surface of the body portion, an active layer including a quantum well structure and provided on the first conductivity type semiconductor layer, and a second conductivity type semiconductor layer provided on the active layer.

The base semiconductor layer and the at least one core may include a material that is the same as a material of the first conductivity type semiconductor layer.

The base semiconductor layer, the at least one core, and the at least one light-emitting portion may include a GaN-based semiconductor material.

The at least one core may include a plurality of cores, the plurality of cores including body portions of different widths in the second direction, and the at least one light-emitting portion may include a plurality of light-emitting portions respectively provided on the plurality of cores.

The plurality of light-emitting portions may have different heights in the first direction.

The plurality of light-emitting portions may have different widths in the second direction.

Each side surface of each body portion of the plurality of cores may include a first portion adjacent to the base semiconductor layer and a second portion above the first portion in the first direction, the light-emitting device may include a plurality of second insulating layers respectively provided on the first portions of the side surfaces of the body portions of the plurality of cores that are adjacent to the base semiconductor layer, and the plurality of second insulating layers may have different heights in the first direction.

The plurality of light-emitting portions may be configured to emit light of different colors.

Each of the plurality of light-emitting portions may include different indium contents.

According to an aspect of the disclosure, a display may include a display panel including a light-emitting structure including a plurality of light-emitting devices and a driving circuit configured to switch the light-emitting structure on and off, and a controller configured to input on-off switching signals for the plurality of light-emitting devices to the driving circuit based on an image signal, where each of the plurality of light-emitting devices may include a base semiconductor layer, at least one core provided on the base semiconductor layer, the at least one core including a body portion extending in a first direction and a shielding portion provided at an upper end of the body portion, where a width of a lower surface of the shielding portion in a second direction orthogonal to the first direction is greater than a width of the body portion in the second direction, a first insulating layer provided on an upper surface of the base semiconductor layer and an upper surface of the shielding portion, and at least one light-emitting portion provided on a side surface of the body portion.

According to an aspect of the disclosure, a method of manufacturing a light-emitting device may include forming a base semiconductor layer on a substrate, forming a mask layer defining at least one growth hole in the base semiconductor layer, forming at least one core including a body portion that at least partially fills the at least one growth hole and extends in a first direction and a shielding portion that extends from the body portion above an upper surface of the mask layer, where a width of a lower surface of the shielding portion in a second direction orthogonal to the first direction is greater than a width of the body portion in the second direction, removing the mask layer, forming a first insulating layer on an upper surface of the base semiconductor layer and an upper surface of the shielding portion, and forming at least one light-emitting portion on a side surface of the body portion.

The base semiconductor layer, the at least one core, and the at least one light-emitting portion may include a GaN-based semiconductor material.

The base semiconductor layer may include a material that is the same as a material of the at least one core.

The side surface of the body portion may include a first portion adjacent to the base semiconductor layer and a second portion above the first portion in the first direction, the method may include, prior to forming the at least one light-emitting portion, forming at least one second insulating layer on the first portion of the side surface of the body portion, the at least one light-emitting portion may be formed on the second portion of the side surface of the body portion that is above the first portion of the side surface of the body portion, and the at least one second insulating layer may not be formed on the second portion of the side surface of the body portion.

The at least one growth hole may include a plurality of growth holes having different sizes, the at least one core may include a plurality of cores, the at least one light-emitting portion may include a plurality of light-emitting portions, the at least one second insulating layer may include a plurality of second insulating layers, the plurality of cores may include body portions of different widths in the second direction are formed in the plurality of growth holes, respectively, the plurality of second insulating layers may have different heights in the first direction, the plurality of second insulating layers respectively corresponding to the plurality of cores, and the plurality of light-emitting portions may be formed on portions of side surfaces of body portions of each of the plurality of cores in which respective second insulating layers of the plurality of second insulating layers are not formed.

### BRIEF DESCRIPTION OF DRAWINGS

The above and other aspects, features, and advantages of certain embodiments of the disclosure will be more apparent from the following description taken in conjunction with the accompanying drawings, in which:
FIG. 1A is a cross-sectional view illustrating a structure of a light-emitting device according to an embodiment;
FIG. 1B is an enlarged view of portion "A" in FIG. 1A illustrating a light-emitting portion according to an embodiment;
FIGS. 2A and 2B are perspective views illustrating various shapes of a core according to an embodiment;
FIG. 3 is a cross-sectional view illustrating a structure of a light-emitting device according to an embodiment;
FIG. 4 is a cross-sectional view illustrating a structure of a light-emitting device according to an embodiment;
FIGS. 5A to 5G are diagrams illustrating a method of manufacturing a light-emitting device according to an embodiment;
FIGS. 6A and 6B are diagrams illustrating a method of manufacturing a light-emitting device according to an embodiment;
FIGS. 7A to 7E are diagrams illustrating a method of manufacturing a light-emitting device according to an embodiment;
FIG. 8 is a diagram illustrating a display according to an embodiment;
FIG. 9 is a block diagram illustrating an electronic device including a display according to an embodiment;
FIG. 10 is a diagram illustrating a mobile device as an example of an electronic device according to an embodiment;
FIG. 11 is a diagram illustrating a head-up display device for vehicle as an example of an electronic device according to an embodiment;
FIG. 12 is a diagram illustrating an augmented-reality glasses or virtual-reality glasses as an example of an electronic device according to an embodiment;
FIG. 13 is a diagram illustrating a signage as an example of an electronic device according to an embodiment; and
FIG. 14 is a diagram illustrating a wearable display as an example of an electronic device according to an embodiment.

### DETAILED DESCRIPTION

Reference will now be made in detail to embodiments, examples of which are illustrated in the accompanying drawings, where like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

As embodiments allow for various changes and numerous embodiments, exemplary embodiments will be illustrated in the drawings and described in detail in the written description. The effects, features of the disclosure and methods for achieving the same may be clarified by referring to the following detailed embodiments along with the drawings. The disclosure may, however, be embodied in many different forms and should not be construed as limited to the exemplary embodiments set forth herein.

Hereinafter, embodiments of the disclosure are explained in detail referring to the attached drawings. When referring to the drawings, like reference numerals may denote like or corresponding elements, and redundant descriptions thereof may be omitted. It will be understood that although the terms "first," "second," etc. may be used herein to describe various components, these components should not be limited by these terms. These components are only used to distinguish one component from another. As used herein, the singular forms "a," "an" and "the" are intended to include the plural forms as well, unless the context clearly indicates otherwise. It will be further understood that the terms "comprises" and/or "includes" used herein specify the presence of stated features or components, but do not preclude the presence or addition of one or more other features or components. In embodiments described below, it will be understood that when a portion, such as a film, an area, a component, etc. is being referred to as being on or above another portion, one portion can be directly on another portion or an intervening film, area, component, etc. may be present thereon.

Sizes of components in the drawings may be exaggerated for convenience of explanation. In other words, since sizes and thicknesses of components in the drawings are arbitrarily illustrated for convenience of explanation, the disclosure is not limited thereto. When a certain embodiment may be implemented differently, a specific process order may be performed differently from the described order. For example, two consecutively described processes may be performed substantially at the same time or performed in an order opposite to the described order.

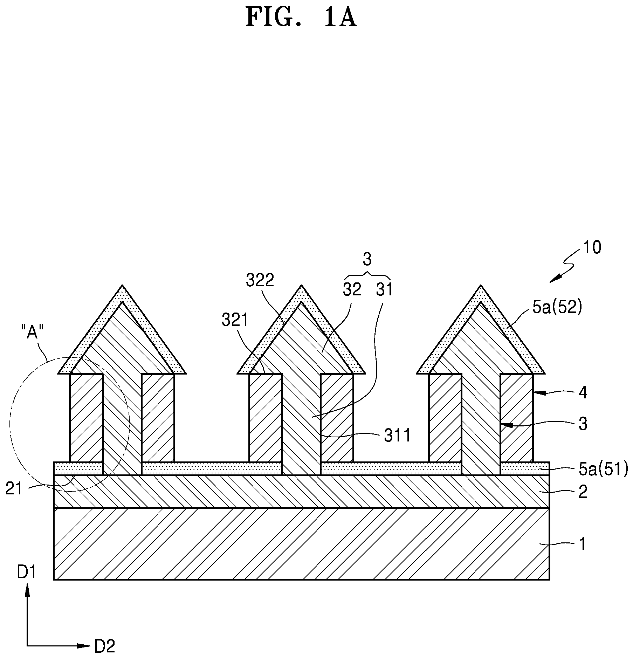

FIG. 1A is a cross-sectional view illustrating a structure of a light-emitting device 10 according to an embodiment. The light-emitting device 10 according to embodiments may be, for example, a micro-light-emitting diode (micro-LED). The light-emitting device 10 according to embodiments may be a nanostructure light-emitting device. In this case, a core 3 may be referred to as a nano-core or nano-rod. Referring to FIG. 1A, the light-emitting device 10 may include a base semiconductor layer 2, at least one core 3 (hereinafter referred to as a single core for convenience of description), a first insulating layer 5a, and a light-emitting portion 4.

The substrate 1 is a growth substrate for semiconductor single crystal growth, and a silicon (Si) substrate, a silicon carbide (SiC) substrate, a sapphire substrate, etc. may be used as the substrate 1. In addition, a material suitable for growth of the base semiconductor layer 2 to be formed on the substrate 1 (for example, AIN, AlGaN, ZnO, GaAs, MgAl₂O₄, MgO, LiAlO₂, LiGaO₂, or GaN, may be used as the substrate 1. Depending on a device to which the light-emitting device 10 is applied, the substrate 1 may be removed after manufacturing of the light-emitting device 10 is completed through a manufacturing process to be described below.

The base semiconductor layer 2 may be formed on the substrate 1. The base semiconductor layer 2 may function as a growth template for the core 3. In an embodiment, the base semiconductor layer 2 may include the same material as the core 3. As a result, crystal defects due to lattice mismatch may be reduced when growing the core 3 on the base semiconductor layer 2. In an embodiment, the base semiconductor layer 2 may include a Group III-V nitride semiconductor material. The base semiconductor layer 2 may be a first conductivity type semiconductor layer doped with a first type impurity. For example, the base semiconductor layer 2 may include a GaN-based semiconductor material. For example, the base semiconductor layer 2 may be a GaN layer doped with an n-type impurity (that is, an n-GaN layer). Si, Ge, Se, Te, etc., may be used as the n-type impurity. A buffer layer for epitaxial growth may be further formed between the substrate 1 and the base semiconductor layer 2. The base semiconductor layer 2 may have a multi-layered structure. Depending on a device to which the light-emitting device 10 is applied, the base semiconductor layer 2 may be removed after manufacturing of the light-emitting device 10 is completed through a manufacturing process to be described below.

The core 3 is formed on the base semiconductor layer 2. The core 3 may include a body portion 31 and a shielding portion 32. The body portion 31 may extend from the base semiconductor layer 2 in a first direction D1 (for example, in a direction perpendicular to an upper surface 21 of the base semiconductor layer 2). A side surface 311 of the body portion 31 is a non-polar plane (that is, an m-plane). The shielding portion 32 is provided at an upper end of the body portion 31. The shielding portion 32 has a lower surface 321 having a width in a second direction D2 (that is perpendicular to the first direction D1) that is greater than a width of the body portion 31 in the second direction D2. The width of the shielding portion 32 in the second direction D2 may gradually decrease with the distance increasing from the lower surface 321 in the first direction D1. Accordingly, the upper surface 322 of the shielding portion 32 has a sharp shape inclined with respect to the lower surface 321. The upper surface 322 of the shielding portion 32 is a semipolar plane (that is, an r-plane).

The core 3 may be formed on the base semiconductor layer 2 using the base semiconductor layer 2 as a template. As described above, the core 3 may include the same material as the base semiconductor layer 2. The core 3 may include a Group III-V nitride semiconductor material. The core 3 may include a first conductivity type semiconductor material doped with a first type impurity. For example, the core 3 may include a GaN-based semiconductor material. For example, the core 3 may include GaN doped with an n-type impurity (that is, n-GaN). Si, Ge, Se, Te, etc. may be used as the n-type impurity.

The first insulating layer 5a at least partially covers the upper surface 21 of the base semiconductor layer 2 and the upper surface 322 of the shielding portion 32. The first insulating layer 5a may include a first portion 51 at least partially covering the upper surface 21 of the base semiconductor layer 2 and a second portion 52 at least partially covering the upper surface 322 of the shielding portion 32. The first insulating layer 5a may include an insulating material, such as silicon oxide or silicon nitride. The first insulating layer 5a may include, for example, SiO₂, SiN, TiO₂, Si₃N₄, Al₂O₃, TiN, AIN, ZrO₂, TiAlN, or TiSiN. Because the width of the shielding portion 32 of the core 3 in the second direction D2 is greater than that of the body portion 31, the shielding portion 32 functions as a mask to prevent an insulating material from being deposited on a side surface 311 of the body portion 31. Therefore, in the process of forming the first insulating layer 5a, no insulating material is deposited on the side surface 311 of the body portion 31. An insulating material may be deposited on the upper surface 21 of the base semiconductor layer 2 and the upper surface 322 of the shielding portion 32, excluding the side surface 311 of the body portion 31.

The light-emitting portion 4 is formed on the side surface 311 of the body portion 31 of the core 3. The light-emitting portion 4 may include a Group III-V nitride semiconductor material. For example, the light-emitting portion 4 may include a GaN-based semiconductor material.

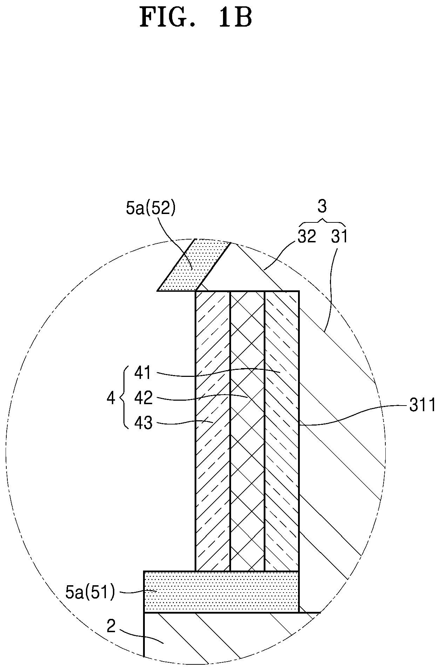

FIG. 1B is an enlarged view of portion "A" in FIG. 1A illustrating a light-emitting portion 4 according to an embodiment. Referring to FIGS. 1A and 1B, the light-emitting portion 4 may have a layered structure grown in the second direction D2 on the side surface 311 of the body portion 31 of the core 3. The light-emitting portion 4 may include a first conductivity type semiconductor layer 41 formed on the side surface 311 of the body portion 31 of the core 3, an active layer 42 having a quantum well structure at least partially covering the first conductivity type semiconductor layer 41, and a second conductivity type semiconductor layer 43 at least partially covering the active layer 42.

The first conductivity type semiconductor layer 41 may be formed by being grown in the second direction D2 on the side surface 311 of the body portion 31 of the core 3. The first conductivity type semiconductor layer 41 may be a semiconductor layer doped with the first type impurity that is the same as those of the base semiconductor layer 2 and the core 3. For example, the first conductivity type semiconductor layer 41 may be an n-GaN layer.

The active layer 42 emits light through electron-hole recombination. The active layer 42 may be formed by being grown in the second direction D2 on the first conductivity type semiconductor layer 41. The active layer 42 has a quantum well structure. For example, the active layer 42 may have a single quantum well or multi quantum well structure made by adjusting a band spacing by periodically changing x, y, and z values in AlₓGa_{y}In_{z}N. For example, a quantum well layer and a barrier layer may be paired in the form of InGaN/GaN, InGaN/InGaN, InGaN/AlGaN, or InGaN/InAlGaN to form a quantum well structure, and the bandgap energy may be controlled according to a composition ratio of indium (In) in a material layer including indium (In), thereby adjusting a light emission wavelength band.

The second conductivity type semiconductor layer 43 may at least partially cover the surface of the active layer 42. The second conductivity type semiconductor layer 43 may be formed by being grown in the second direction D2 on the active layer 42. The second conductivity type semiconductor layer 43 may be a semiconductor layer doped with a second type impurity. For example, the second conductivity type semiconductor layer 43 may be a p-GaN layer doped with a p-type impurity. Mg, Zn, Be, etc. may be used as the p-type impurity.

The light-emitting portion 4 may be formed by methods, such as hybrid vapor phase epitaxy (HVPE), molecular beam epitaxy (MBE), metal organic vapor phase epitaxy (MOVPE), and metal organic chemical vapor deposition (MOCVD). When the light-emitting portion 4 is grown, the first insulating layer 5a blocks the light-emitting portion 4 from growing in areas other than the side surface 311 of the body portion 31 of the core 3. In addition, the first insulating layer 5a (for example, the first portion 51 formed on the base semiconductor layer 2) insulates the base semiconductor layer 2 from the second conductivity type semiconductor layer 43 of the light-emitting portion 4.

In the case of a conventional light-emitting portion grown on a crystal plane (0001 plane) in a c-axis direction (which is a polar plane), a quantum confinement stark effect (QCSE) may occur due to polarization caused by a piezoelectric field effect. This may cause a decrease in internal quantum efficiency. The above-mentioned problem of a light-emitting portion grown on the polar plane may become worse as the indium (In) content of the light-emitting portion increases and the emission wavelength becomes longer.

In the light-emitting device 10 according to embodiments, the light-emitting portion 4 is formed by being grown on the side surface 311 of the body portion 31 of the core 3. The side surface 311 of the body portion 31 of the core 3 is a non-polar plane (that is, an m-plane). Therefore, the problem of lowering internal quantum efficiency due to an internal magnetic field may be solved. In addition, polarization due to the piezoelectric field effect may be suppressed, and thus, the QCSE may be suppressed. Accordingly, internal quantum efficiency may be increased. Additionally, when the indium (In) content of the light-emitting portion 4 increases, the occurrence of crystal defects may be reduced. As a result, it becomes easy to maintain a uniform high indium (In) content within the light-emitting portion 4, and as a result, color purity may be increased. In addition, the light-emitting portion 4 that generates red light with high efficiency may be implemented. Because the light-emitting portion 4 is formed around the body portion 31 of the core 3, the light-emitting device 10 having the light-emitting portion 4 with an increased emission area compared to a planar light-emitting structure stacked in the first direction D1 may be implemented.

In addition, because the shielding portion 32 of the core 3 functions as a mask to prevent the first insulating layer 5a from being formed on the side surface 311 of the body portion 31, a process of forming a mask for selectively forming the first insulating layer 5a and a process of removing the mask after forming the first insulating layer 5a may be omitted. Accordingly, a process of manufacturing the light-emitting device 10 may be simplified and manufacturing costs may be reduced. In addition, the risk of damage and performance deterioration of the light-emitting device 10 due to the mask formation and removal process may be reduced, and thus, a reliable light-emitting device 10 may be manufactured.

The shape of the light-emitting device 10 may vary. For example, the shape of the light-emitting device 10 may depend on the shape of the core 3.

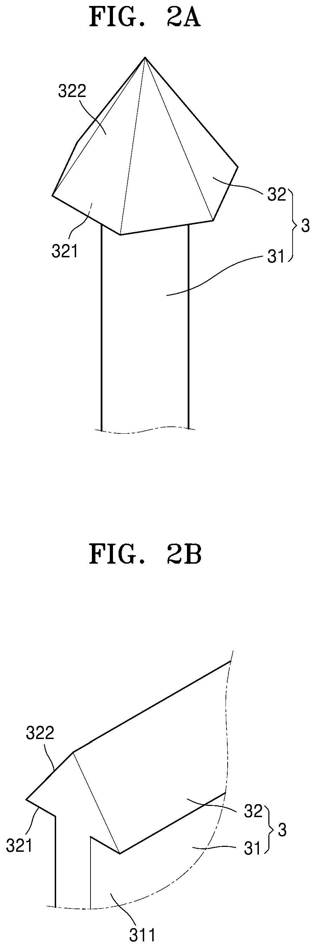

FIGS. 2A and 2B are perspective views illustrating various shapes of a core 3 according to an embodiment. Referring to FIG. 2A, the body portion 31 of the core 3 may be pillar-shaped. The cross-sectional shape of the body portion 31 of the core 3 orthogonal to the first direction D1 may have various shapes, such as a circular shape, an oval shape, or a polygonal shape. The shape of the shielding portion 32 of the core 3 may be determined by the crystal lattice form of a material forming the core 3. For example, in the case of the core 3 including GaN, the shielding portion 32 may have a hexahedral shape with a hexagonal bottom. As shown in FIG. 2B, the body portion 31 of the core 3 may have a stripe shape extending in the second direction D2. The shape of the core 3 is not limited to the shapes shown in FIGS. 2A and 2B. The core 3 may have various shapes including a shielding portion 32 having a width in the second direction D2 that is greater than a width of the body portion 31 in the second direction D2.

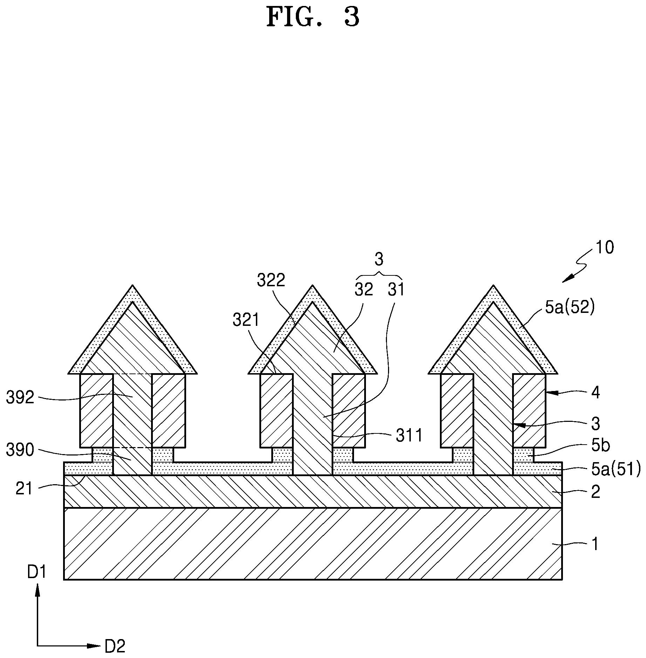

FIG. 3 is a cross-sectional view illustrating a structure of a light-emitting device 10 according to an embodiment. The embodiment of the light-emitting device 10 shown in FIG. 3 is different from the embodiment of the light-emitting device 10 shown in FIGS. 1A, 1B, 2A, and 2B in that an insulating layer is partially formed on the side surface 311 of the body portion 31 of the core 3. Repeated description of aspects shown in FIGS. 1A, 1B, 2A, and 2B may be omitted.

Referring to FIG. 3, the light-emitting device 10 may include a second insulating layer 5b that at least partially covers the side surface 311 of the body portion 31 of the core 3. The second insulating layer 5b at least partially covers a portion (e.g., portion 390) of the side surface 311 of the body portion 31, the portion 390 being adjacent to the base semiconductor layer 2. For example, an insulating layer 53 extends from the first insulating layer 5a (for example, the first portion 51) formed on the base semiconductor layer 2 along the side surface 311 of the body portion 31 in the first direction D1. The second insulating layer 5b may include, for example, SiO₂, SiN, TiO₂, Si₃N₄, Al₂O₃, TiN, AIN, ZrO₂, TiAlN, or TiSiN. For example, the second insulating layer 5b may be formed together with the first insulating layer 5a in the process of forming the first insulating layer 5a. The light-emitting portion 4 is formed on a portion of the side surface 311 of the body portion 31 in which the second insulating layer 5b is not formed. For example, the light-emitting portion 4 may be formed on a portion of the side surface 311 of the body portion 31 that is between the second insulating layer 5b and the lower surface 321 of the shielding portion 32. As shown in FIG. 3, an adjacent portion 390 (i.e., a first portion) may be adjacent to the base semiconductor layer 2, and a non-adjacent portion 392 (i.e., a second portion) may be above the adjacent portion 390 in the first direction D1. The non-adjacent portion 392 may have the light-emitting portion 4 formed thereon, and the adjacent portion 390 may have the insulating layers 5a and 5b formed thereon.

A portion of the side surface 311 of the body portion 31 that is adjacent to the base semiconductor layer 2 (hereinafter, referred to as an adjacent portion) may refer to a portion close to the upper surface 21 of the base semiconductor layer 2 (which is a polar plane), and the quality of the adjacent portion as a non-polar plane may be relatively low compared to that of a portion further away from the base semiconductor layer 2 in the first direction D1. When the light-emitting portion 4 is formed on the entire side surface 311 of the body portion 31 including the adjacent portion, the half-width of an emission wavelength may increase due to a difference in material composition of the light-emitting portion 4 in the first direction D1, thereby deteriorating the emission quality. According to embodiments, because the second insulating layer 5b is formed in the adjacent portion, the light-emitting portion 4 is not grown in the adjacent portion of the side surface 311 of the body portion 31. The light-emitting portion 4 is formed on a portion (e.g., portion 392) of the side surface 311 of the body portion 31, which is above the adjacent portion in the first direction D1. That is, because the light-emitting portion 4 is grown on a non-polar plane of relatively good quality, the material composition of the light-emitting portion 4 may be uniform in the first direction D1. As a result, an increase in the half width of the emission wavelength due to a difference in the material composition of the light-emitting portion 4 may be prevented.

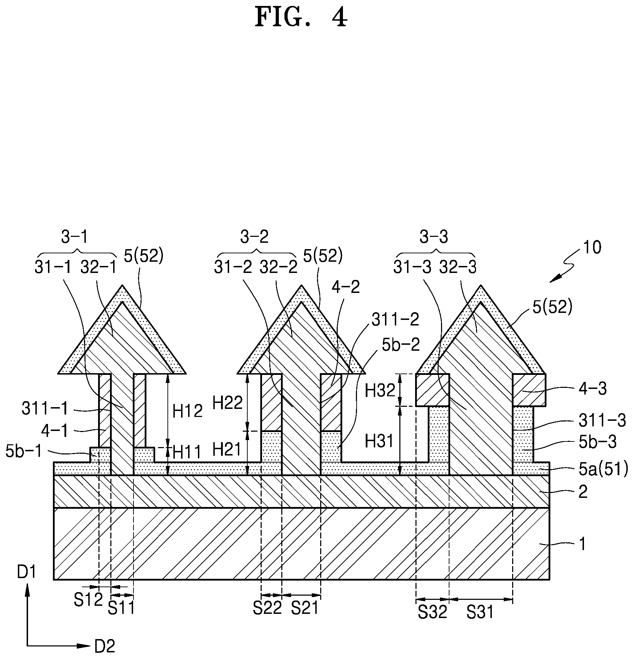

FIG. 4 is a cross-sectional view illustrating a structure of a light-emitting device 10 according to an embodiment. The embodiment of the light-emitting device 10 shown in FIG. 4 is different from the embodiment of the light-emitting device 10 shown in FIGS. 1 to 3 in that the light-emitting device 10 shown in FIG. 4 includes a plurality of cores with body portions 31 of different widths in the second direction D2. Repeated description of aspects shown in FIGS. 1A, 1B, 2A, 2B, and 3 may be omitted.

Referring to FIG. 4, a plurality of cores having different widths in the second direction D2 (for example, cores 3-1, 3-2, and 3-3), and a plurality of light-emitting portions 4-1, 4-2, and 4-3 corresponding to the cores 3-1, 3-2, and 3-3, respectively are shown. Here, the 'width of the core in the second direction D2' may refer to the diameter of an equivalent circle corresponding to the cross-section of a body portion when the body portion has a column shape with a cross-section of, for example, a circular, oval, or polygonal shape, or may refer to the minimum diameter of a circle including the cross-section of the body portion. In addition, when the body portion has a stripe shape, the 'width of the core in the second direction D2' may refer to the width of the body portion in a short axis direction.

The cores 3-1, 3-2, and 3-3 include body portions 31-1, 31-2, and 31-3 and shielding portions 32-1, 32-2, and 32-3, respectively. The widths of the body portions 31-1, 31-2, and 31-3 in the second direction D2 are S11, S21, and S31, respectively. In some embodiments, S11<S21<S31. In some embodiments, the heights of the body portions 31-1, 31-2, and 31-3 in the first direction D1 are the same, but at least one of the body portions 31-1, 31-2, and 31-3 may have a different height from the rest. The description of the body portion 31 given above applies to the body portions 31-1, 31-2, and 31-3. The width of each of the shielding portions 32-1, 32-2, and 32-3 in the second direction D2 may be greater than the widths of the body portions 31-1, 31-2, and 31-3 in the second direction D2. The description of the shielding portion 32 given above applies to the shielding portions 32-1, 32-2, and 32-3.

The first insulating layer 5a may include a first portion 51 formed on the upper surface 21 of the base semiconductor layer 2 and second portions 52 respectively formed on the upper surfaces of the shielding portions 32-1, 32-2, and 32-3. Second insulating layers 5b-1, 5b-2, and 5b-3 at least partially cover the side surfaces 311-1, 311-2, and 311-3 of the body portions 31-1, 31-2, and 31-3, respectively. The description of the second insulating layer 5b given above applies to the second insulating layer 5b-1, 5b-2, and 5b-3. The heights of the second insulating layers 5b-1, 5b-2, and 5b-3 in the first direction D1 may be different from each other. For example, when the heights of the second insulating layers 5b-1, 5b-2, and 5b-3 in the first direction D1 are H11, H21, and H31, respectively, H11 < H21 < H31.

Light-emitting portions 4-1, 4-2, and 4-3 are respectively formed on portions of the side surfaces of the body portions 31-1, 31-2, and 31-3, which are not covered by the second insulating layers 5b-1, 5b-2, and 5b-3. The description of the light-emitting portion 4 given above applies to the light-emitting portions 4-1, 4-2, and 4-3. The indium (In) contents of the light-emitting portions 4-1, 4-2, and 4-3 may be different from each other. The heights of the light-emitting portions 4-1, 4-2, and 4-3 in the first direction D1 may be different from each other. As described above, the heights of the body portions 31-1, 31-2, and 31-3 in the first direction D1 may be the same, and the heights of the second insulating layers 5b-1, 5b-2, and 5b-3, in the first direction D1, respectively formed on the side surfaces 311-1, 311-2, and 311-3 of the body portions 31-1, 31-2, and 31-3 may be different from each other. In an embodiment, when the heights of the light-emitting portions 4-1, 4-2, and 4-3 in the first direction D1 are respectively H12, H22, and H32, H12>H22>H32. The widths of the light-emitting portions 4-1, 4-2, and 4-3 in the second direction D2 may be different from each other. When the widths of the light-emitting portions 4-1, 4-2, and 4-3 in the second direction D2 are respectively S12, S22, and S32, S12<S22<S32.

The light-emitting portions 4-1, 4-2, and 4-3 may emit light having different colors (that is, different wavelengths). In the case of a GaN-based light-emitting portion, the emission wavelength depends on the content of indium (In). The higher the indium (In) content, the longer the emission wavelength. In the process of manufacturing the light-emitting portions 4-1, 4-2, and 4-3, the total amounts of indium (In) supplied per unit time to the cores 3-1, 3-2, and 3-3 are the same. Therefore, the smaller the sizes of the light-emitting portions 4-1, 4-2, and 4-3, the higher the indium (In) content. In the embodiment shown in FIG. 4, the light-emitting portion 4-1 with the smallest width S12 has the highest content of indium (In), and the light-emitting portion 4-3 with the largest width S32 has the lowest content of indium (In). Therefore, in terms of the emission wavelength, the emission wavelength becomes shorter in the order of the light-emitting portion 4-1, the light-emitting portion 4-2, and the light-emitting portion 4-3. For example, the widths of the light-emitting portions 4-1, 4-2, and 4-3 in the second direction D2 may be adjusted such that the light-emitting portions 4-1, 4-2, and 4-3 emit red light R, green light G, and blue light B, respectively. The widths S12, S22, and S32 of the light-emitting portions 4-1, 4-2, and 4-3 in the second direction D2 may be adjusted by the heights H12, H22, and H32 of the light-emitting portions 4-1, 4-2, and 4-3 in the first direction D1. The heights H12, H22, and H32 of the light-emitting portions 4-1, 4-2, and 4-3 in the first direction D1 may be adjusted by the heights H11, H21, and H31 of the second insulating layers 5b-1, 5b-2, and 5b-3 in the first direction D1. As a result, the light-emitting portions 4-1, 4-2, and 4-3 are grown on the non-polar plane, thereby suppressing the QCSE, and thus, a monolithic color light-emitting device capable of emitting three-color light with stable wavelength characteristics may be implemented.

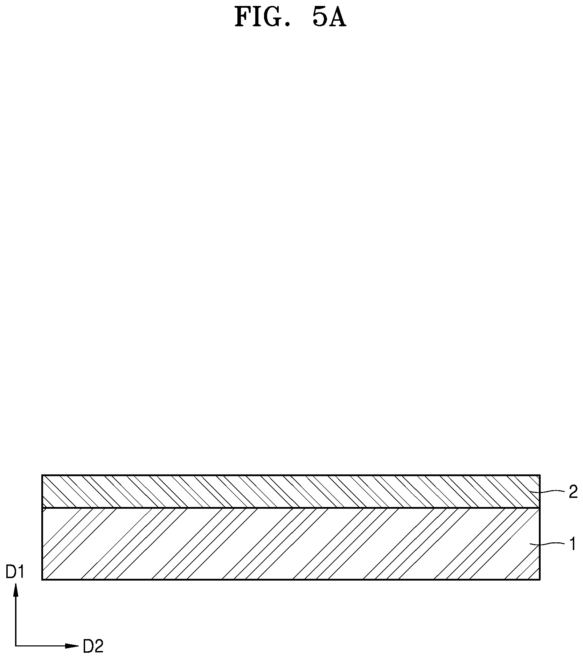

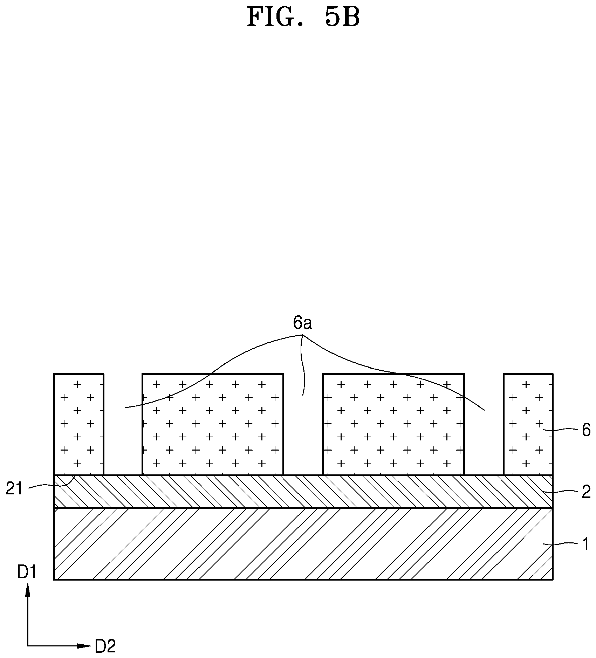

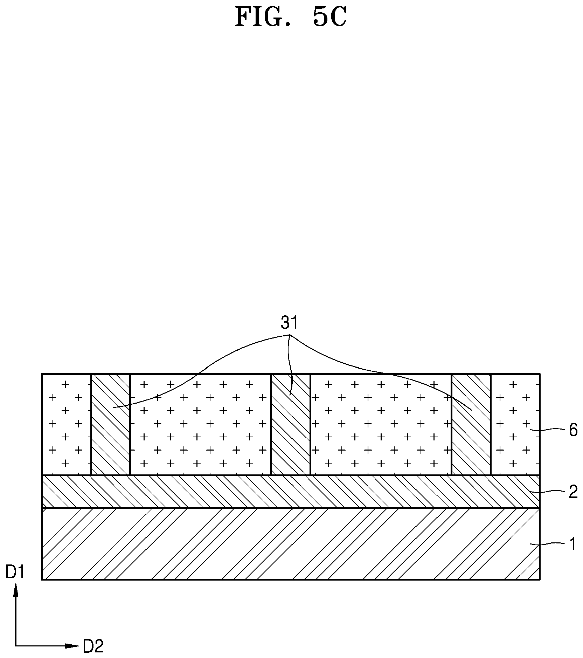

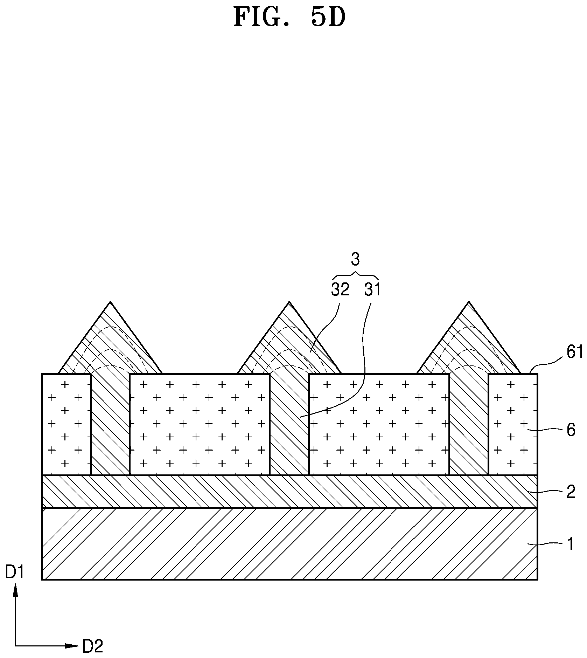

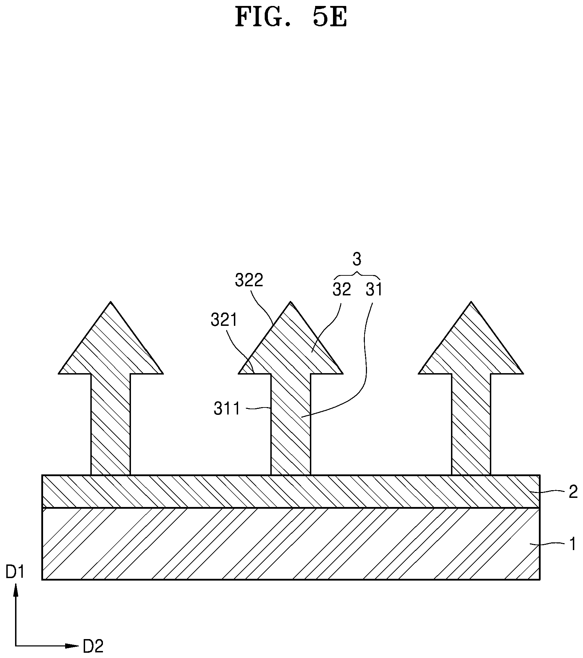

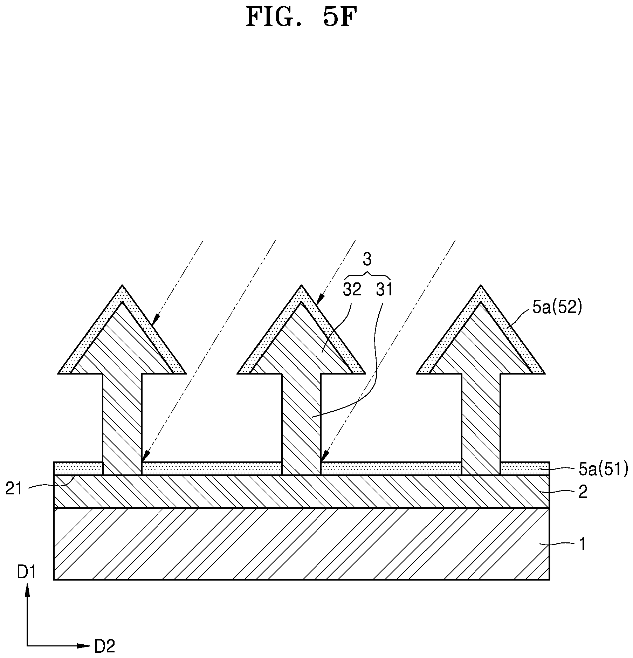

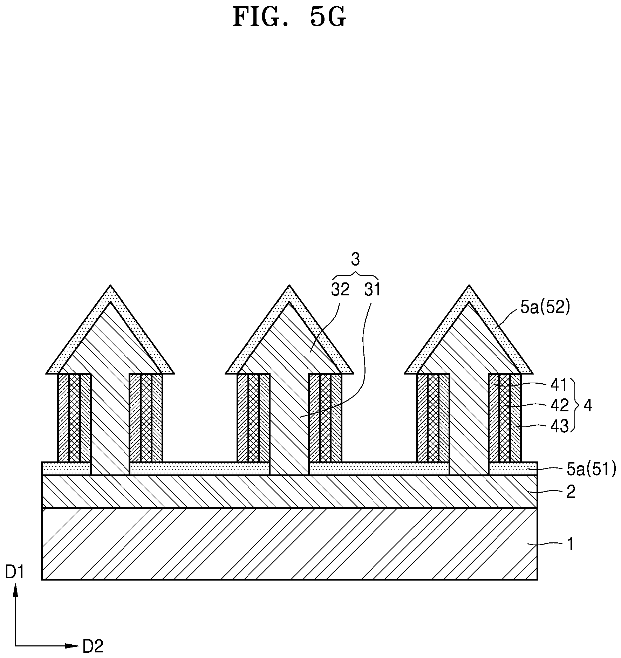

FIGS. 5A to 5G are diagrams illustrating a method of manufacturing a light-emitting device 10 according to an embodiment. The method of manufacturing the light-emitting device 10 according to an embodiment may include forming a base semiconductor layer 2 on a substrate 1 (see FIG. 5A), forming a mask layer 6 defining a growth hole 6a on the base semiconductor layer 2 (see FIG. 5B), forming a core 3 having a body portion 31 filling the growth hole 6a and a shielding portion 32 larger than the body portion 31 (see FIGS. 5C and 5D), removing the mask layer 6 (see FIG. 5E), forming a first insulating layer 5a (see FIG. 5F), and forming a light-emitting portion 4 on a side surface 311 of the body portion 31 (see FIG. 5G). Below, each operation will be described in detail.

Referring to FIG. 5A, the base semiconductor layer 2 is formed on the substrate 1. The substrate 1 is a growth substrate for semiconductor single crystal growth, and a silicon (Si) substrate, a silicon carbide (SiC) substrate, a sapphire substrate, etc. may be used as the substrate 1. In addition, a substrate including a material suitable for the growth of the base semiconductor layer 2 to be formed on the substrate 1 may be used (for example, AIN, AlGaN, ZnO, GaAs, MgAl₂O₄, MgO, LiAlO₂, LiGaO₂, or GaN). In an embodiment, the base semiconductor layer 2 may include a Group III-V nitride semiconductor material (for example, a GaN-based semiconductor material). The base semiconductor layer 2 may be a first conductivity type semiconductor layer. The base semiconductor layer 2 may be formed by various methods, such as HVPE, MBE, MOVPE, and MOCVD. For example, GaN may be grown on the substrate 1 and doped with an n-type impurity, such as Si, Ge, Se, or Te, to form an n-GaN layer. A buffer layer for epitaxial growth may be further formed between the substrate 1 and the base semiconductor layer 2.

Referring to FIG. 5B, a mask layer 6 defining at least one growth hole 6a is formed on the base semiconductor layer 2. For example, after forming the mask layer 6 that entirely covers the upper surface 21 of the base semiconductor layer 2, the mask layer 6 may be etched by a lithography method (for example, a photo lithography method or an electron beam lithography method), and thus, at least one growth hole 6a may be formed in the mask layer 6. The growth hole 6a may have various shapes, such as circular, oval, polygonal, and striped shapes. The upper surface 21 of the base semiconductor layer 2 is partially exposed through the growth hole 6a. The mask layer 6 may include SiO₂, TiO₂, Si₃N₄, Al₂O₃, TiN, AIN, ZrO₂, TiAlN, TiSiN, etc. For example, after forming a SiO₂ layer that entirely covers the upper surface 21 of the base semiconductor layer 2, the SiO₂ layer may be etched to form the growth hole 6a exposing the upper surface 21 of the base semiconductor layer 2. The height of the mask layer 6 in the first direction D1 may correspond to the height of the body portion 31 of the core 3, to be formed later, in the first direction D1.

Next, forming the core 3 grown from the upper surface 21 of the base semiconductor layer 2 through the growth hole 6a is performed. In an embodiment, the core 3 may include a Group III-V nitride semiconductor material (for example, a GaN-based semiconductor material). The core 3 may be a first conductivity type semiconductor layer. The core 3 may be formed by various methods, such as HVPE, MBE, MOVPE, and MOCVD. For example, GaN may be grown from the upper surface 21 of the base semiconductor layer 2 through the growth hole 6a. GaN grows from the upper surface 21 of the base semiconductor layer 2 in the first direction D1 to at least partially fill the inside of the growth hole 6a. When GaN fills the entire inside of the growth hole 6a, as shown in FIG. 5C, the body portion 31 extending from the upper surface 21 of the base semiconductor layer 2 in the first direction D1 is formed. After filling the entire inside of the growth hole 6a, GaN gradually grows from an upper end of the body portion 31 in the first direction D1, as shown by the dotted line in FIG. 5D, and also grows in the second direction D2 orthogonal to the first direction D1 along an upper surface 61 of the mask layer 6. The lower surface 321 of the shielding portion 32 extends in the second direction D2 along the upper surface 61 of the mask layer 6. Accordingly, the width of the lower surface 321 of the shielding portion 32 in the second direction D2 may be greater than that of the body portion 31. The shape of the shielding portion 32 may be determined by the crystal lattice structure of a material forming the core 3. The shielding portion 32 having a width in the second direction D2 that is greater than a width of the body portion 31 in the second direction D2 is formed on the upper surface 61 of the mask layer 6. For example, when the core 3 includes GaN, the shielding portion 32 may have a seven-sided shape with a hexagonal bottom.

Next, the mask layer 6 is removed (for example, by a wet etching process). As a result, as shown in FIG. 5E, the upper surface 21 of the base semiconductor layer 2 may be exposed, and the core 3, which includes the body portion 31 extending from the upper surface 21 of the base semiconductor layer 2 in the first direction D1 and the shielding portion 32 having a width in the second direction D2 that is greater than a width of the body portion 31 in the second direction D2, may be formed. The shielding portion 32 has a lower surface 321 having a width in the second direction D2 that is greater than a width of the body portion 31 in the second direction D2, and an upper surface 322 that extends obliquely from the lower surface 321 in the first direction D1 and is sharp overall. The core 3 may include the same material as the base semiconductor layer 2 (for example, a first conductivity type semiconductor material). In some embodiments, the base semiconductor layer 2 is a GaN-based first conductivity type semiconductor layer (that is, an n-GaN layer). The core 3 including GaN may be doped with an n-type impurity, such as Si, Ge, Se, or Te. Accordingly, the core 3 may include the same n-GaN as the base semiconductor layer 2.

Next, forming the first insulating layer 5a is performed. The first insulating layer 5a is formed to at least partially cover a polar plane and a semipolar plane. The first insulating layer 5a may not be formed on a non-polar plane. The first insulating layer 5a may include an insulating material (for example, SiO₂, TiO₂, Si₃N₄, Al₂O₃, TiN, AIN, ZrO₂, TiAlN, or TiSiN). In some embodiments, the first insulating layer 5a includes SiO₂. For example, the first insulating layer 5a may be formed by plasma deposition. The upper surface 21 of the base semiconductor layer 2 is a polar plane. The upper surface 322 of the shielding portion 32 is a semipolar plane. The side surface 311 of the body portion 31 is a non-polar plane. Because the upper surface 21 of the base semiconductor layer 2 and the upper surface 322 of the shielding portion 32 are not covered by the shielding portion 32, as shown in FIG. 5F, an insulating material is deposited on the upper surface 21 of the base semiconductor layer 2 and the upper surface 322 of the shielding portion 32 to form a first insulating layer 5a (for example, a first portion 51 and a second portion 52). Because the width of the shielding portion 32 in the second direction D2 is greater than that of the body portion 31, the shielding portion 32 functions as a blocking unit (for example, a mask), that prevents the first insulating layer 5a from being formed on the side surface 311 of the body portion 31. In low step coverage conditions, process conditions, such as process temperature and process pressure, may be adjusted so that an insulating material is not deposited on the side surface 311 of the body portion 31 due to the shadow effect of the shielding portion 32. As a result, no insulating material is deposited on the side surface 311 of the body portion 31, and the first insulating layer 5a may be formed on the upper surface 21 of the base semiconductor layer 2 and the upper surface 322 of the shielding portion 32.

Next, as shown in FIG. 5G, forming the light-emitting portion 4 on the side surface 311 of the body portion 31 (which is a non-polar plane) is performed. The light-emitting portion 4 may include a Group III-V nitride semiconductor material (for example, a GaN-based semiconductor material). The light-emitting portion 4 may be formed by sequentially growing a first conductivity type semiconductor layer 41, an active layer 42, and a second conductivity type semiconductor layer 43 on the side surface 311 of the body portion 31 by using various methods, such as HVPE, MBE, MOVPE, and MOCVD.

An n-GaN layer is grown as the first conductivity type semiconductor layer 41 on the side surface 311 of the body portion 31. The first conductivity type semiconductor layer 41 grows from the side surface 311 of the body portion 31 in the second direction D2. Because the upper surface 21 of the base semiconductor layer 2 and the upper surface 322 of the shielding portion 32 are at least partially covered by the first insulating layer 5a, the n-GaN layer is not grown thereon. Next, the active layer 42 is grown on the first conductivity type semiconductor layer 41. The active layer 42 may have a single quantum well or multi quantum well structure. A quantum well layer and a barrier layer may be paired in the form of InGaN/GaN, InGaN/InGaN, InGaN/AlGaN, or InGaN/InAlGaN to form a quantum well structure. The active layer 42 grows from the first conductivity type semiconductor layer 41 in the second direction D2. Next, the second conductivity type semiconductor layer 43 at least partially covering the active layer 42 is grown. The second conductivity type semiconductor layer 43 is grown from the active layer 42 in the second direction D2. For example, the second conductivity type semiconductor layer 43 is a p-GaN layer.

The light-emitting device 10 according to an embodiment shown in FIGS. 1A and 1B may be manufactured through the process shown in FIGS. 5A to 5G described above. A process of forming electrodes for supplying current to the first conductivity type semiconductor layer 41 and the second conductivity type semiconductor layer 43 may be further performed.

In order to obtain a core extending in the first direction D1 on the base semiconductor layer 2, a method of forming on the base semiconductor layer 2 an n-GaN layer having uniform thickness and etching the n-GaN layer to form the core may be considered. In this case, the core formed by etching (that is, the side surface of a body portion) may become uneven. In order to obtain a body portion having a uniform side, an annealing process may be added after etching. In addition, a separate process may be required to form a shielding portion after forming the body portion. According to the manufacturing method of some embodiments, GaN is grown inside the growth hole 6a defined by the mask layer 6. Therefore, the core 3 having the body portion 31 may be formed, and it is easy to control the shape of the body portion 31 of the core 3. In addition, a core 3 with a high aspect ratio may be formed. In addition, as GaN grows beyond the mask layer 6, the shielding portion 32 is naturally formed. In other words, the body portion 31 and the shielding portion 32 are formed through the same process. Therefore, the manufacturing process may be simplified.

In order to obtain a light-emitting portion grown on a non-polar plane, the light-emitting portion may be prevented from growing on a polar plane and a semipolar plane. To this end, a method of forming a mask for protecting the non-polar plane when forming a first insulating layer at least partially covering the polar plane and the semipolar plane and removing the mask after forming the first insulating layer at least partially covering the polar plane and the semipolar plane may be considered. The process of forming/removing the mask involves an etching process, which may damage the core. In addition, when allowing the light-emitting portion to grow on a semipolar plane, additional processes, such as etching a grown light-emitting portion or forming a high-resistance layer on the light-emitting portion, may be added such that the light-emitting portion grown on the semipolar plane does not emit light. This additional process may cause damage or deterioration of performance of the manufactured light-emitting device.

According to the manufacturing method of some embodiments, when forming the first insulating layer 5a at least partially covering the upper surface 21 of the base semiconductor layer 2 (which is a polar plane), and the upper surface 322 of the shielding portion 32 (which is a semipolar plane), the shielding portion 32 of the core 3 functions as a mask that protects the side surface 311 of the body portion 31 (which is a non-polar plane). Therefore, the process of forming/removing a mask to protect the non-polar plane may be omitted, and thus, the manufacturing process may be simplified, the manufacturing cost may be reduced, and the risk of damage to the core 3 in the manufacturing process may be reduced..

The body portion 31 includes the same material as the first conductivity type semiconductor layer 41 (for example, n-GaN). Accordingly, the lattice mismatch between the body portion 31 and the first conductivity type semiconductor layer 41 may be minimized, and thus, a first conductivity type semiconductor layer 41 grown with good quality and an active layer 42 grown on the first conductivity type semiconductor layer 41 may be obtained. In addition, the side surface 311 of the body portion 31 is a non-polar plane. Accordingly, the problem of lowering internal quantum efficiency due to an internal magnetic field may be solved, and polarization due to the piezoelectric field effect may be suppressed, thereby suppressing the QCSE. Accordingly, the light-emitting portion 4 with increased internal quantum efficiency may be implemented.

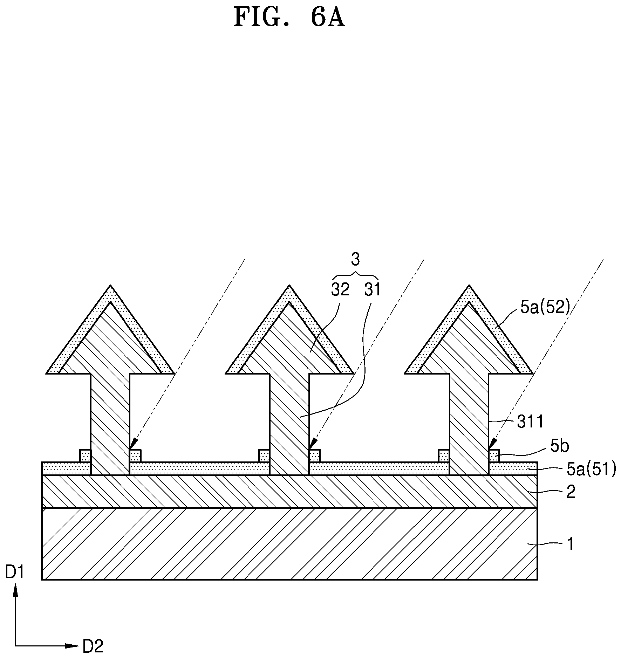

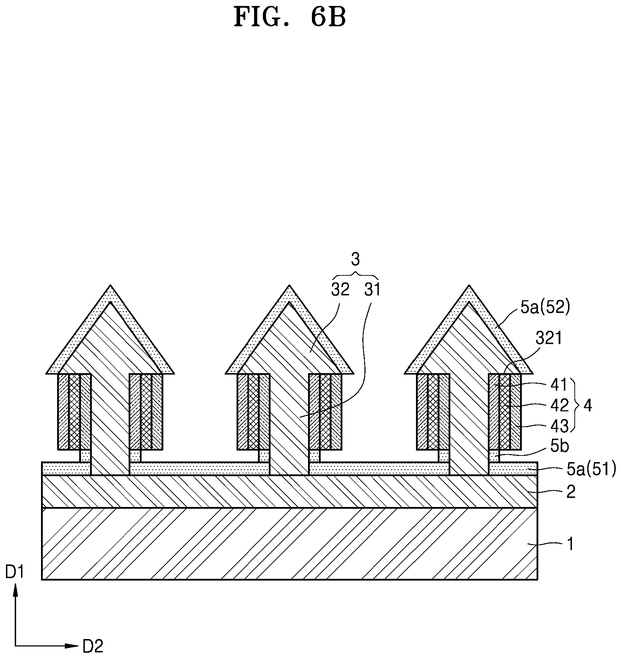

FIGS. 6A and 6B are diagrams illustrating a method of manufacturing a light-emitting device 10 according to an embodiment. Hereinafter, differences from the embodiment of the manufacturing method shown in FIGS. 5A to 5G will be mainly described, and repeated descriptions will be omitted.

First, the process shown in FIGS. 5A to 5E described above is performed. As a result, as shown in FIG. 5E, the core 3, which includes the body portion 31 extending from the upper surface 21 of the base semiconductor layer 2 in the first direction D1 and the shielding portion 32 having a width in the second direction D2 that is greater than a width of the body portion 31 in the second direction D2, is formed.

Next, forming first and second insulating layers 5a and 5b is performed. The first and second insulating layers 5a and 5b may include an insulating material (for example, SiO₂, TiO₂, Si₃N₄, Al₂O₃, TiN, AIN, ZrO₂, TiAlN, or TiSiN). In some embodiments, the first and second insulating layers 5a and 5b include SiO₂. For example, the first and second insulating layers 5a and 5b may be formed by plasma deposition. The first insulating layer 5a is formed on the upper surface 21 of the base semiconductor layer 2 (which is a polar plane), and the upper surface 322 of the shielding portion 32 (which is a semipolar plane), and the second insulating layer 5b is formed to at least partially cover a portion of the side surface 311 of the body portion 31 (which is a non-polar plane) that is adjacent to the base semiconductor layer 2. Because the upper surface 21 of the base semiconductor layer 2 and the upper surface 322 of the shielding portion 32 are not covered by the shielding portion 32, an insulating material is deposited on the upper surface 21 of the base semiconductor layer 2 and the upper surface 322 of the shielding portion 32 to form a first insulating layer 5a including a first portion 51 and a second portion 52. Because the width of the shielding portion 32 in the second direction D2 is greater than that of the body portion 31, the side surface 311 of the body portion 31 is at least partially covered by the shielding portion 32. In low step coverage conditions, process conditions, such as process temperature and process pressure, may be adjusted such that an insulating material is not deposited on a portion of the side surface 311 of the body portion 31 that is above the adjacent portion (e.g., portion 392 that is above portion 390 of FIG. 3) due to the shadow effect of the shielding portion 32 and, as indicated by an arrow in FIG. 6A, an insulating material is deposited on the portion of the side surface 311 of the body portion 31 that is adjacent to the base semiconductor layer 2. As a result, the first insulating layer 5a may be formed on the upper surface 21 of the base semiconductor layer 2 and the upper surface 322 of the shielding portion 32, and the second insulating layer 5b may be formed on the portion of the side surface 311 of the body portion 31 that is adjacent to the base semiconductor layer 2.

Next, a process of forming the light-emitting portion 4 is performed as shown in FIG. 6B. The process of forming the light-emitting portion 4 is the same as described in FIG. 5G. The light-emitting portion 4 is formed on a portion of the side surface 311 of the body portion 31 that is above the portion adjacent to the base semiconductor layer 2 and on which the second insulating layer 5b is not formed (that is, the light-emitting portion 4 is formed on a portion between the second insulating layer 5b and the lower surface 321 of the shielding portion 32). As a result, the light-emitting device 10 according to an embodiment shown in FIG. 3 may be manufactured.

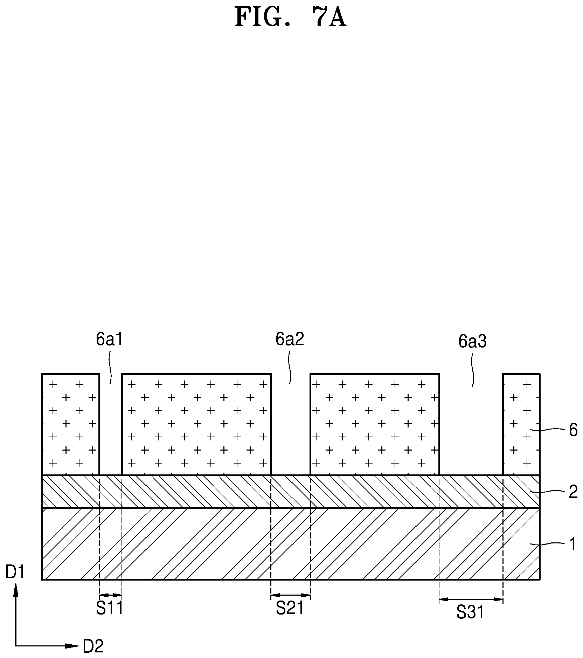

FIGS. 7A to 7E are diagrams illustrating a method of manufacturing a light-emitting device 10 according to an embodiment. Hereinafter, differences from the embodiment of the manufacturing method shown in FIGS. 5A to 5G will be mainly described, and repeated descriptions will be omitted.

First, as shown in FIG. 5A, a base semiconductor layer 2 is formed on the substrate 1. The base semiconductor layer 2 may include a Group III-V nitride semiconductor material (for example, a GaN-based semiconductor material). The base semiconductor layer 2 may be a first conductivity semiconductor layer (for example, an n-GaN layer). For example, GaN may be grown on the substrate 1 and doped with an n-type impurity, such as Si, Ge, Se, or Te, to form the base semiconductor layer 2 (which is an n-GaN layer).

Next, forming the mask layer 6 is performed. Referring to FIG. 7A, a mask layer defining growth holes having different widths in the second direction D2 on the base semiconductor layer 2 (for example, growth holes 6a1, 6a2, and 6a3) is formed. The widths of the growth holes 6a1, 6a2, and 6a3 in the second direction D2 are S11, S21, and S31, respectively, and may be S11 <S21 <S31. For example, after forming the mask layer 6 that entirely covers the upper surface 21 of the base semiconductor layer 2, the mask layer 6 may be etched by a lithography method (for example, a photo lithography method or an electron beam lithography method), and thus, the growth holes 6a1, 6a2, and 6a3 may be formed in the mask layer 6. The growth holes 6a1, 6a2, and 6a3 may have various shapes, such as circular, oval, polygonal, and striped shapes. The upper surface 21 of the base semiconductor layer 2 is exposed by the growth holes 6a1, 6a2, and 6a3. The mask layer 6 may include SiO₂, TiO₂, Si₃N₄, Al₂O₃, TiN, AIN, ZrO₂, TiAlN, TiSiN, etc. For example, after forming a SiO₂ layer that entirely covers the upper surface 21 of the base semiconductor layer 2, the SiO₂ layer may be etched to form the growth holes 6a1, 6a2, and 6a3 exposing the upper surface 21 of the base semiconductor layer 2. The height of the mask layer 6 in the first direction D1 may correspond to the height of the body portion 31 of the core 3, to be formed later, in the first direction D1.

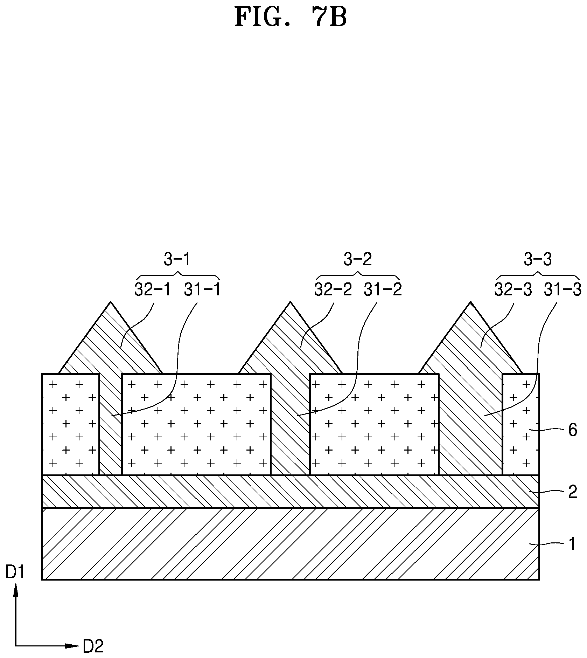

Next, as shown in FIG. 7B, forming cores 3-1, 3-2, and 3-3 grown from the upper surface 21 of the base semiconductor layer 2 through the growth holes 6a1, 6a2 and 6a3 is performed. The forming of the cores 3-1, 3-2, and 3-3 may be performed with the same as the process shown in FIGS. 5D and 5E described above. For example, GaN may be grown from the upper surface 21 of the base semiconductor layer 2 through the growth holes 6a1, 6a2, and 6a3. As GaN grows from the upper surface 21 of the base semiconductor layer 2 in the first direction D1 to fill the insides of the growth holes 6a1, 6a2, and 6a3, body portions 31-1, 31-2, and 31-3 extending from the upper surface 21 of the base semiconductor layer 2 in the first direction D1 are formed. After filling the entire insides of the growth holes 6a1, 6a2, and 6a3, GaN gradually grows from upper ends of the body portions 31-1, 31-2, and 31-3 in the first direction D1, as shown by the dotted line in FIG. 5D, and also grows in the second direction D2 orthogonal to the first direction D1 along the upper surface 61 of the mask layer 6. The shape of the shielding portion 32 may be determined by the crystal lattice structure of a material forming the core 3. Shielding portions 32-1, 32-2, and 32-3 having widths in the second direction D2 that are greater than the widths of the body portions 31-1, 31-2, and 31-3 in the second direction D2 are formed on the upper surface 61 of the mask layer 6.

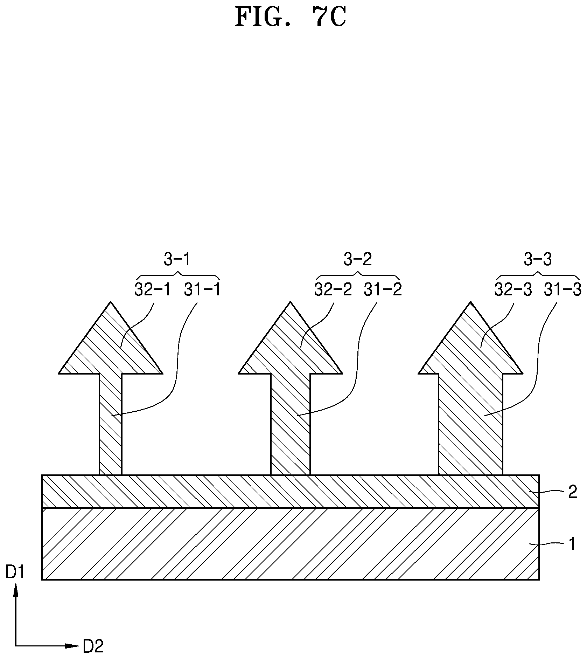

Next, the mask layer 6 is removed (for example, by a wet etching process). As a result, as shown in FIG. 7C, the upper surface 21 of the base semiconductor layer 2 may be exposed, and the cores 3-1, 3-2, and 3-3, which respectively include the body portions 31-1, 31-2, and 31-3 extending from the upper surface 21 of the base semiconductor layer 2 in the first direction D1 and the shielding portions 32-1, 32-2, and 32-3 having widths in the second direction D2 that are greater than the widths of the body portions 31-1, 31-2, and 31-3 in the second direction D2, may be formed. The cores 3-1, 3-2, and 3-3 may include the same material as the base semiconductor layer 2 (for example, a first conductivity type semiconductor material). In some embodiments, the base semiconductor layer 2 is a GaN-based first conductivity type semiconductor layer (for example, an n-GaN layer). The cores 3-1, 3-2, and 3-3 including GaN may be doped with an n-type impurity, such as Si, Ge, Se, or Te. Accordingly, the cores 3-1, 3-2, and 3-3 may include the same n-GaN as the base semiconductor layer 2.

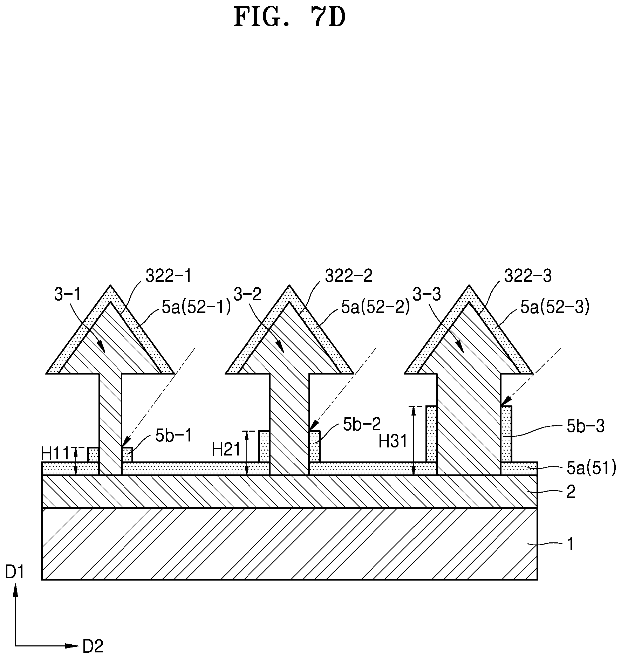

Next, forming the first and second insulating layers 5a and 5b is performed, as shown in FIG. 7D. The first and second insulating layers 5a and 5b may include an insulating material (for example, SiO₂, TiO₂, Si₃N₄, Al₂O₃, TiN, AIN, ZrO₂, TiAlN, or TiSiN). In some embodiments, the first and second insulating layers 5a and 5b include SiO₂. For example, the first and second insulating layers 5a and 5b may be formed by plasma deposition. The first insulating layer 5a is formed on the upper surface 21 of the base semiconductor layer 2 (which is a polar plane), and the upper surfaces 322-1, 322-2, and 322-3 of the shielding portions 32-1, 32-2, and 32-3 (which are semipolar planes). The second insulating layer 5b is formed to at least partially cover portions which are adjacent to the base semiconductor layer 2, of the side surfaces 311-1, 311-2, and 311-3 of the body portions 31-1, 31-2, and 31-3 (which are non-polar planes). Because the upper surface 21 of the base semiconductor layer 2 and the upper surfaces 322-1, 322-2, and 322-3 of the shielding portions 32-1, 32-2, and 32-3 are not covered by the shielding portions 32-1, 32-2, and 32-3, an insulating material is deposited on the upper surface 21 of the base semiconductor layer 2 and the upper surfaces 322-1, 322-2, and 322-3 of the shielding portions 32-1, 32-2, and 32-3 to form a first portion 51 and second portions 52-1, 52-2, and 52-3. Because the widths of the shielding portions 32-1, 32-2, and 32-3 in the second direction D2 are greater than those of the body portions 31-1, 31-2, and 31-3, the side surfaces 311-1, 311-2, and 311-3 of the body portions 31-1, 31-2, and 31-3 are at least partially covered by the shielding portions 32-1, 32-2, and 32-3. As shown by arrows in FIG. 7D, an insulating material is deposited on portions of the side surfaces 311-1, 311-2, and 311-3 of the body portions 31-1, 31-2, and 31-3 that are adjacent to the upper surface 21 of the base semiconductor layer 2. Thus, second insulating layers 5b-1, 5b-2, and 5b-3 may be formed on the side surfaces 311-1, 311-2, and 311-3 of the body portion 31-1, 31-2, and 31-3. Process conditions, such as process temperature and process pressure, may be determined such that an insulating material may be partially deposited onto portions of the side surfaces 311-1, 311-2, and 311-3 of the body portions 31-1, 31-2, and 31-3 that are adjacent to the upper surface 21 of the base semiconductor layer 2. The widths of the shielding portions 32-1, 32-2, and 32-3 in the second direction D2 are approximately the same. The widths of the body portions 31-1, 31-2, and 31-3 in the second direction D2 are different from each other and have a relationship of S11 <S21 <S31, and thus, the extent to which the shading effect of the shielding portions 32-1, 32-2, and 32-3 affects each of the body portions 31-1, 31-2, and 31-3 varies. Accordingly, the heights of the second insulating layers 5b-1, 5b-2, and 5b-3 respectively formed on the side surfaces 311-1, 311-2, and 311-3 of the body portions 31-1, 31-2, and 31-3 vary. When the heights of the second insulating layers 5b-1, 5b-2, and 5b-3 in the first direction D1 are respectively H11, H21, and H31, H11 <H21 <H31.

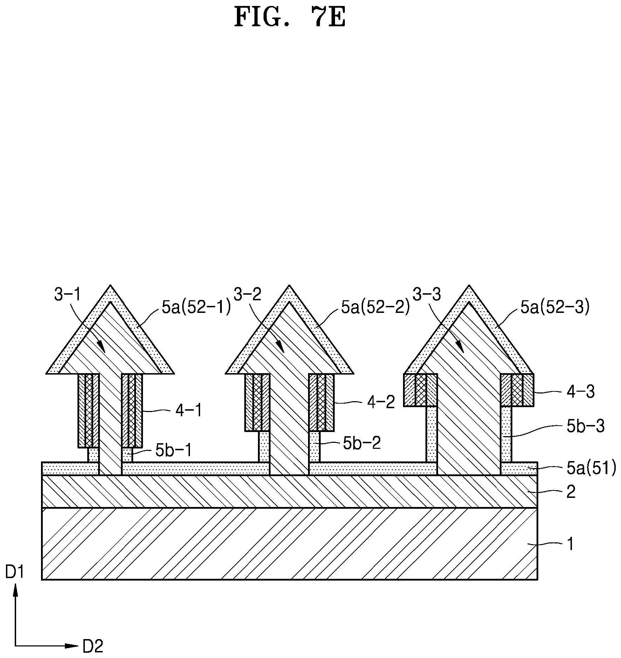

Next, as shown in FIG. 7E, forming light-emitting portions 4-1, 4-2, and 4-3 on the side surfaces 311-1, 311-2, and 311-3 of the body portions 31-1, 31-2, and 31-3, which are non-polar planes, is performed. The process of forming the light-emitting portions 4-1, 4-2, and 4-3 may be the same as the process described with reference to FIG. 5G. The structure of each of the light-emitting portions 4-1, 4-2, and 4-3 may be the same as that of the light-emitting portion 4. The light-emitting portions 4-1, 4-2, and 4-3 are formed on portions of the side surfaces 311-1, 311-2, and 311-3 of the body portions 31-1, 31-2, and 31-3 which are not covered by the second insulating layer 5b-1, 5b-2, and 5b-3. Accordingly, the light-emitting portions 4-1, 4-2, and 4-3 may be formed with different heights in the first direction D1 and different widths in the second direction D2.

As a result, the light-emitting device 10 according to an embodiment shown in FIG. 4 may be manufactured.

Hereinafter, various examples of electronic devices to which the embodiments of the light-emitting device 10 described above are applied will be described. The electronic devices may be displays or may be various devices including displays.

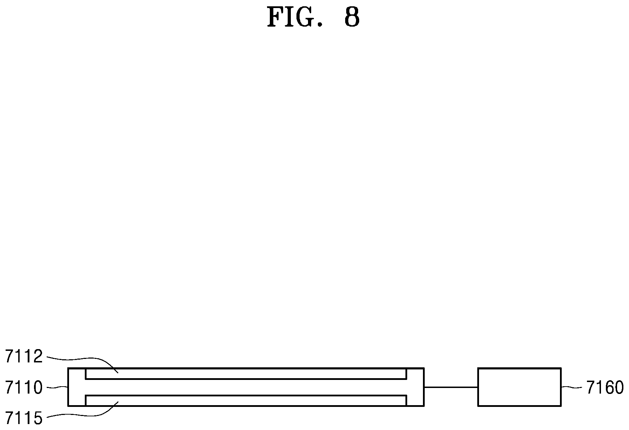

FIG. 8 is a diagram illustrating a display according to an embodiment. Referring to FIG. 8, the display may include a display panel 7110 and a controller 7160. The display panel 7110 has a light-emitting structure 7112 and a driving circuit 7115 that switches the light-emitting structure 7112 on and off. The light-emitting structure 7112 may include a plurality of light-emitting devices 10 described with reference to FIGS. 1 to 7E. The plurality of light-emitting devices 10 may be arranged, for example, in a two-dimensional array. The driving circuit 7115 has a plurality of switching elements for individually switching on-off the plurality of light-emitting devices 10. The controller 7160 inputs on-off switching signals of the plurality of light-emitting devices 10 to the driving circuit 7115 according to an image signal.

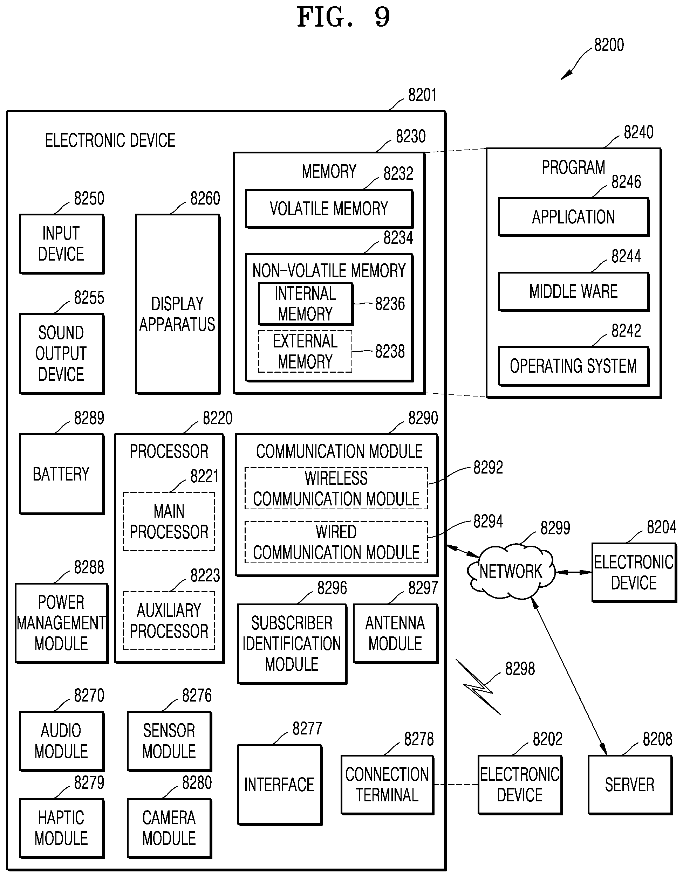

FIG. 9 is a block diagram illustrating an electronic device including a display according to an embodiment. Referring to FIG. 9, the electronic device 8201 may be provided in a network environment 8200. In the network environment 8200, the electronic device 8201 may communicate with another electronic device 8202 through a first network 8298 (a short-range wireless communication network, etc.) or with another electronic device 8204 and/or a server 8208 through a second network 8299 (a remote wireless communication network, etc.). The electronic device 8201 may communicate with the electronic device 8204 through the server 8208. The electronic device 8201 may include a processor 8220, a memory 8230, an input device 8250, a sound output device 8255, a display apparatus 8260, an audio module 8270, a sensor module 8276, an interface 8277, a haptic module 8279, a camera module 8280, a power management module 8288, a battery 8289, a communication module 8290, a subscriber identification module 8296, and/or an antenna module 8297. The electronic device 8201 may omit some of these components or may further include other components. Some of these components may be implemented as an integrated circuit. For example, the sensor module 8276 (a fingerprint sensor, an iris sensor, an illuminance sensor, etc.) may be embedded in the display apparatus 8260 (a display, etc.)

The processor 8220 may execute software (a program 8240, etc.) to control one or more components (hardware, software, etc.) of the electronic device 8201 connected to the processor 8220 and to perform various data processing or computation operations. As part of the data processing or computation operations, the processor 8220 may be configured to load a command and/or data received from other components (the sensor module 8276, the communication module 8290, etc.) into a volatile memory 8232, process the command and/or the data stored in the volatile memory 8232, and store resulting data in a non-volatile memory 8234. The processor 8220 may include a main processor 8221 (a central processing unit, an application processor, etc.) and an auxiliary processor 8223 (a graphics processing unit, an image signal processor, a sensor-hub processor, a communication processor, etc.) which may operate separately from or together with the main processor 8221. The auxiliary processor 8223 may use less power than the main processor 8221 and may perform specialized functions.

The auxiliary processor 8223 may operate instead of the main processor 8221, when the main processor 8221 is in an inactive state (a sleep state), may operate together with the main processor 8221, when the main processor 8221 is in an active state (an application execution state), and may control a function and/or a state associated with one or more components (the display apparatus 8260, the sensor module 8276, the communication module 8290, etc.) of the electronic device 8201. The auxiliary processor 8223 (the image signal processor, the communication processor, etc.) may be implemented as part of other functionally related components (the camera module 8280, the communication module 8290, etc.).

The memory 8230 may store various data required by the components (the processor 8220, the sensor module 8276, etc.) of the electronic device 8201. The data may include, for example, the software (the program 8240, etc.), and input data and/or output data with respect to a command related to the software. The memory 8230 may include the volatile memory 8232 and/or the non-volatile memory 8234.

The program 8240 may be stored in the memory 8230 as software and may include an operating system 8242, middleware 8244, and/or an application 8246.

The input device 8250 may receive a command and/or data to be used for the components (the processor 8220, etc.) of the electronic device 8201, from the outside (a user, etc.) of the electronic device 8201. The input device 8250 may include a remote controller, a microphone, a mouse, a keyboard, and/or a digital pen (a stylus pen, etc.).

The sound output device 8255 may output a sound signal to the outside of the electronic device 8201. The sound output device 8255 may include a speaker and/or a receiver. The speaker may be used for a general purpose, such as reproducing multimedia content or recording content, and the receiver may be used to receive an incoming call. The receiver may be integrated as part of the speaker or separately provided from the speaker.

The display apparatus 8260 may visually provide data to the outside of the electronic device 8201. The display apparatus 8260 may include a display, a hologram device, or a control circuit configured to control a projector and a corresponding device. The display apparatus 8260 may include the display described with reference to FIG. 8. The display apparatus 8260 may include the light-emitting device 10 described with reference to FIGS. 1 to 7E. The display apparatus 8260 may include touch circuitry configured to sense a touch operation and/or sensor circuitry (a pressure sensor, etc.) configured to measure an intensity of a force generated by the touch operation.

The audio module 8270 may convert sound into an electrical signal or an electrical signal into sound. The audio module 8270 may obtain sound via the input device 8250 or may output sound via the sound output device 8255 and/or a speaker and/or a headphone of another electronic device (the electronic device 8202, etc.) directly or wirelessly connected to the electronic device 8201.

The sensor module 8276 may sense an operation state (power, temperature, etc.) of the electronic device 8201 or an external environmental state (a user state, etc.) and generate electrical signals and/or data values corresponding to the sensed state. The sensor module 8276 may include a gesture sensor, a gyro-sensor, an atmospheric sensor, a magnetic sensor, an acceleration sensor, a grip sensor, a proximity sensor, a color sensor, an infrared (IR) sensor, a biometric sensor, a temperature sensor, a humidity sensor, and/or an illuminance sensor.

The interface 8277 may support one or more designated protocols to be used for the electronic device 8201 to be directly or wirelessly connected to another electronic device (the electronic device 8202, etc.). The interface 8277 may include a high-definition multimedia interface (HDMI) interface, a universal serial bus (USB) interface, a secure digital (SD) card interface, and/or an audio interface.

A connection terminal 8278 may include a connector, through which the electronic device 8201 may be physically connected to another electronic device (the electronic device 8202, etc.). The connection terminal 8278 may include an **HDMI** connector, a USB connector, an SD card connector, and/or an audio connector (a headphone connector, etc.).

The haptic module 8279 may convert an electrical signal into a mechanical stimulus (vibration, motion, etc.) or an electrical stimulus which is recognizable to a user via haptic or motion sensation. The haptic module 8279 may include a motor, a piezoelectric device, and/or an electrical stimulus device.

The camera module 8280 may capture a still image and a video. The camera module 8280 may include a lens assembly including one or more lenses, image sensors, image signal processors, and/or flashes. The lens assemblies included in the camera module 8280 may collect light emitted from an object, an image of which is to be captured.

The power management module 8288 may manage power supplied to the electronic device 8201. The power management module 8288 may be realized as part of a power management integrated circuit (PMIC).

The battery 8289 may supply power to the components of the electronic device 8201. The battery 8289 may include a non-rechargeable primary battery, rechargeable secondary battery, and/or a fuel battery.

The communication module 8290 may support establishment of direct (wired) communication channels and/or wireless communication channels between the electronic device 8201 and other electronic devices (the electronic device 8202, the electronic device 8204, the server 8208, etc.) and communication performance through the established communication channels. The communication module 8290 may include one or more communication processors separately operating from the processor 8220 (an application processor, etc.) and supporting direct communication and/or wireless communication. The communication module 8290 may include a wireless communication module 8292 (a cellular communication module, a short-range wireless communication module, a global navigation satellite system (GNSS) communication module, and/or a wired communication module 8294 (a local area network (LAN) communication module, a power line communication module, etc.). From these communication modules, a corresponding communication module may communicate with other electronic devices through the first network 8298 (a short-range wireless communication network, such as Bluetooth, WiFi direct, or infrared data association (IrDA)) or the second network 8299 (a remote communication network, such as a cellular network, the Internet, or a computer network (LAN, WAN, etc.)). Various types of communication modules described above may be integrated as a single component (a single chip, etc.) or realized as a plurality of components (a plurality of chips). The wireless communication module 8292 may identify and authenticate the electronic device 8201 within the first network 8298 and/or the second network 8299 by using subscriber information (international mobile subscriber identification (IMSI), etc.) stored in the subscriber identification module 8296.

The antenna module 8297 may transmit a signal and/or power to the outside (other electronic devices, etc.) or receive the same from the outside. The antenna may include an emitter including a conductive pattern formed on a substrate (a printed circuit board (PCB), etc.). The antenna module 8297 may include an antenna or a plurality of antennas. When the antenna module 8297 includes a plurality of antennas, an appropriate antenna which is suitable for a communication method used in the communication networks, such as the first network 8298 and/or the second network 8299, may be selected. Through the selected antenna, signals and/or power may be transmitted or received between the communication module 8290 and other electronic devices. In addition to the antenna, another component (a radio frequency integrated circuit (RFIC), etc.) may be included in the antenna module 8297.

Some of the components of the electronic device 8201 may be connected to one another and exchange signals (commands, data, etc.) with one another, through communication methods performed among peripheral devices (a bus, general purpose input and output (GPIO), a serial peripheral interface (SPI), a mobile industry processor interface (MIPI), etc.).

The command or the data may be transmitted or received between the electronic device 8201 and another external electronic device 8204 through the server 8208 connected to the second network 8299. The other electronic devices 8202 and 8204 may be electronic devices that are homogeneous or heterogeneous types with respect to the electronic device 8201. All or part of operations performed in the electronic device 8201 may be performed by one or more of the other electronic devices 8202, 8204, and 8208. For example, when the electronic device 8201 has to perform a function or a service, instead of directly performing the function or the service, the one or more other electronic devices may be requested to perform part or all of the function or the service. The one or more other electronic devices receiving the request may perform an additional function or service related to the request and may transmit a result of the execution to the electronic device 8201. To this end, cloud computing, distribution computing, and/or client-server computing techniques may be used.

The electronic device 8201 may be applied to various devices. Various components of the electronic device 8201 described above may be properly changed according to functions of the device, and other proper components may be added to perform the functions of the device. Hereinafter, example applications of the electronic device 8201 are described.

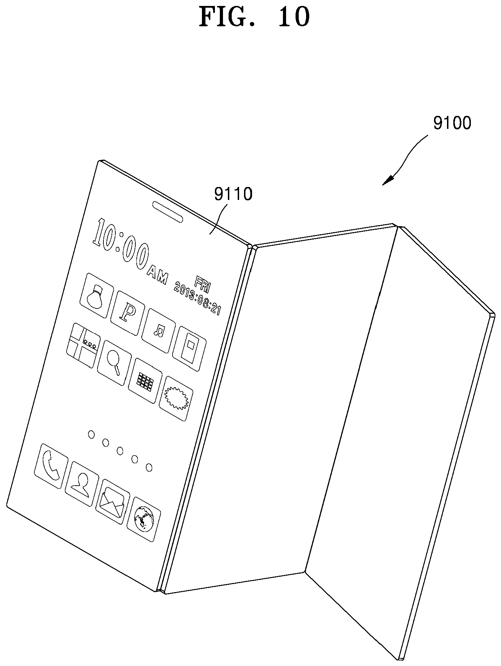

FIG. 10 is a diagram illustrating a mobile device as an example of an electronic device according to an embodiment. A mobile device 9100 may include a display device 9110. The display device 9110 may include the display described with reference to FIG. 8. The display device 9110 may include the light-emitting device 10 described with reference to FIGS. 1 to 7E. The display device 9110 may have a foldable structure, for example, a multi-foldable structure.

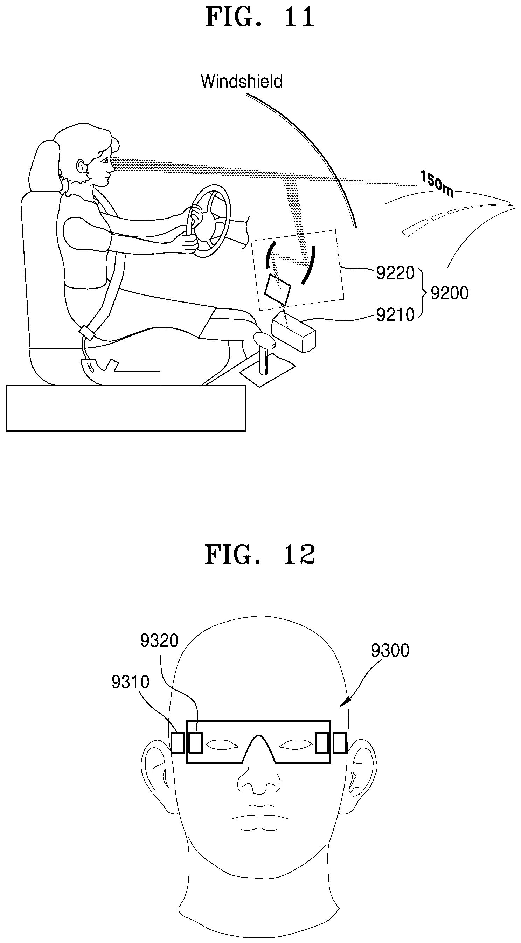

FIG. 11 is a diagram illustrating a head-up display device for vehicle as an example of an electronic device according to an embodiment. A head-up display device for vehicle 9200 may include a display 9210 provided in an area of a vehicle and an optical path change member 9220 configured to change an optical path so that a driver can see an image generated at the display 9210. The display 9210 may include the display described with reference to FIG. 8. The display 9210 may include the light-emitting device 10 described with reference to FIGS. 1 to 7E.

FIG. 12 is a diagram illustrating an augmented-reality glasses or virtual-reality glasses as an example of an electronic device according to an embodiment. The augmented-reality glasses (or virtual-reality glasses) 9300 may include a projection system 9310 configured to form an image and an element 9320 configured to guide the image from the projection system 9310 to user's eyes. The projection system 9310 may include the display described with reference to FIG. 8. The projection system 9310 may include the light-emitting device 10 described with reference to FIGS. 1 to 7E.

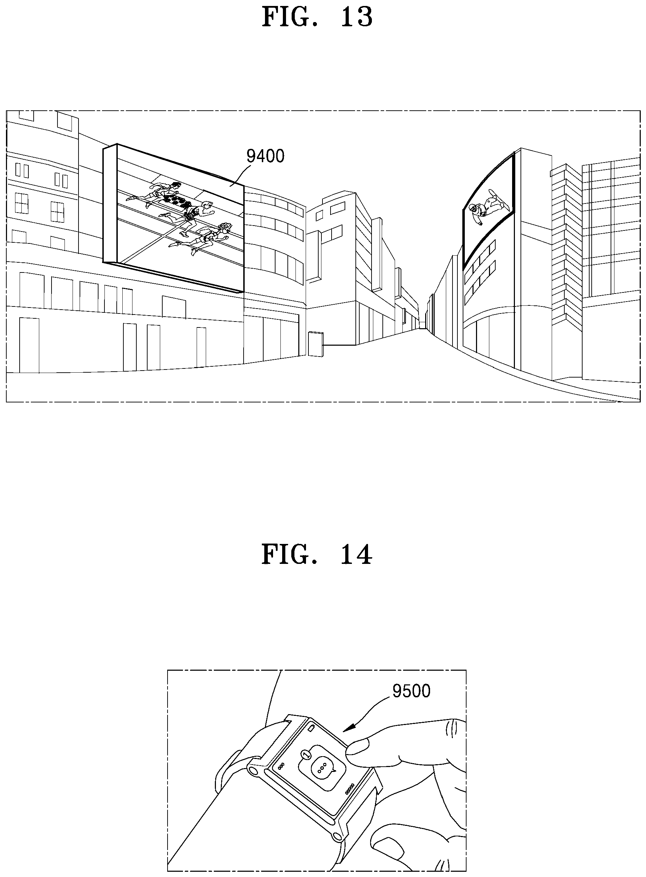

FIG. 13 is a diagram illustrating a signage as an example of an electronic device according to an embodiment. A signage 9400 may include the display described with reference to FIG. 8. The signage 9400 may include the light-emitting device 10 described with reference to FIGS. 1 to 7E. The signage 9400 may be used in outdoor advertising using a digital information display, and may control contents, etc. of an advertisement though a network. The signage 9400 may be implemented by, for example, the electronic device described with reference to FIG. 9.

FIG. 14 is a diagram illustrating a wearable display as an example of an electronic device according to an embodiment. A wearable display 9500 may include the display described with reference to FIG. 8. The wearable display 9500 may include the light-emitting device described with reference to FIGS. 1 to 7E, and may be implemented by the electronic device described with reference to FIG. 9.

The light-emitting device or the display including the light-emitting device according to an embodiment may also be applied to various products such as rollable television (TV), stretchable display, etc.

According to embodiments of the light-emitting device described above and the method of manufacturing the same, polarization phenomenon may be suppressed and light-emitting efficiency may be increased. According to embodiments of the light-emitting device described above and the method of manufacturing the same, a light-emitting device having an increased emission area may be implemented.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A light-emitting device (10) comprising:
a base semiconductor layer (2);
at least one core (3) provided on the base semiconductor layer, the at least one core comprising:
a body portion (31) extending in a first direction; and
a shielding portion (32) provided at an upper end of the body portion, wherein a width of a lower surface of the shielding portion in a second direction orthogonal to the first direction is greater than a width of the body portion in the second direction;
a first insulating layer (5A) provided on an upper surface of the base semiconductor layer and an upper surface of the shielding portion; and
at least one light-emitting portion (4) provided on a side surface of the body portion.

2. The light-emitting device of claim 1, wherein the width of the shielding portion in the second direction gradually decreases from the lower surface of the shielding portion toward an upper end of the shielding portion in the first direction.

3. The light-emitting device of claim 1 or 2, wherein the side surface of the body portion is a non-polar plane.

4. The light-emitting device of any preceding claim, wherein the side surface of the body portion comprises a first portion (51) adjacent to the base semiconductor layer and a second portion (52) above the first portion in the first direction.
wherein the light-emitting device further comprises a second insulating layer (5B) provided on the first portion of the side surface of the body portion that is adjacent to the base semiconductor layer,
wherein the at least one light-emitting portion is provided on the second portion of the side surface of the body portion that is above the first portion of the side surface of the body portion, and
wherein the second insulating layer is not formed on the second portion of the side surface of the body portion.

5. The light-emitting device of any preceding claim, wherein the base semiconductor layer comprises a material that is the same as a material of the at least one core.

6. The light-emitting device of any preceding claim, wherein the at least one light-emitting portion comprises:
a first conductivity type semiconductor layer (41) provided on the side surface of the body portion;
an active layer (42) comprising a quantum well structure and provided on the first conductivity type semiconductor layer; and
a second conductivity type semiconductor layer (43) provided on the active layer, and optionally wherein the base semiconductor layer and the at least one core comprise a material that is the same as a material of the first conductivity type semiconductor layer.

7. The light-emitting device of any preceding claim, wherein the base semiconductor layer, the at least one core, and the at least one light-emitting portion comprise a GaN-based semiconductor material.

8. The light-emitting device of any preceding claim, wherein the at least one core comprises a plurality of cores, the plurality of cores comprising body portions of different widths in the second direction, and
wherein the at least one light-emitting portion comprises a plurality of light-emitting portions respectively provided on the plurality of cores, and optionally wherein the plurality of light-emitting portions have different heights in the first direction.

9. The light-emitting device of claim 8, wherein the plurality of light-emitting portions have different widths in the second direction.

10. The light-emitting device of claim 8 or 9, wherein each side surface of each body portion of the plurality of cores comprises a first portion adjacent to the base semiconductor layer and a second portion above the first portion in the first direction,
wherein the light-emitting device further comprises a plurality of second insulating layers respectively provided on the first portions of the side surfaces of the body portions of the plurality of cores that are adjacent to the base semiconductor layer, and
wherein the plurality of second insulating layers have different heights in the first direction.

11. The light-emitting device of claim 8, 9 or 10, wherein the plurality of light-emitting portions are configured to emit light of different colors.

12. The light-emitting device of any of claims 8 to 11, wherein each of the plurality of light-emitting portions comprises different indium contents.

13. A display comprising:
a display panel comprising:
a light-emitting structure comprising a plurality of light-emitting devices according to any preceding claim; and
a driving circuit configured to switch the light-emitting structure on and off; and
a controller configured to input on-off switching signals for the plurality of light-emitting devices to the driving circuit based on an image signal.

14. A method of manufacturing a light-emitting device, the method comprising:
forming a base semiconductor layer (2) on a substrate (1);
forming a mask layer (6) defining at least one growth hole in the base semiconductor layer;
forming at least one core comprising:
a body portion (31) that at least partially fills the at least one growth hole and extends in a first direction; and
a shielding portion (32) that extends from the body portion above an upper surface of the mask layer, wherein a width of a lower surface of the shielding portion in a second direction orthogonal to the first direction is greater than a width of the body portion in the second direction;
removing the mask layer;
forming a first insulating layer (5a) on an upper surface of the base semiconductor layer and an upper surface of the shielding portion; and
forming at least one light-emitting portion (4) on a side surface of the body portion.

15. The method of claim 14, wherein the at least one growth hole comprises a plurality of growth holes having different sizes,
wherein the at least one core comprises a plurality of cores,
wherein the at least one light-emitting portion comprises a plurality of light-emitting portions,
wherein the at least one second insulating layer comprises a plurality of second insulating layers,
wherein the plurality of cores comprises body portions of different widths in the second direction are formed in the plurality of growth holes, respectively,
wherein the plurality of second insulating layers have different heights in the first direction, the plurality of second insulating layers respectively corresponding to the plurality of cores, and
wherein the plurality of light-emitting portions are formed on portions of side surfaces of body portions of each of the plurality of cores in which respective second insulating layers of the plurality of second insulating layers are not formed.

## Patentansprüche

1. Lichtemittierende Vorrichtung (10), umfassend:
eine Basishalbleiterschicht (2);
mindestens einen Kern (3), der auf der Basishalbleiterschicht bereitgestellt ist, wobei der mindestens eine Kern Folgendes umfasst:
einen Körperabschnitt (31), der sich in einer ersten Richtung erstreckt; und
einen Abschirmabschnitt (32), der an einem oberen Ende des Körperabschnitts bereitgestellt ist, wobei eine Breite einer unteren Oberfläche des Abschirmabschnitts in einer zweiten Richtung orthogonal zu der ersten Richtung größer als eine Breite des Körperabschnitts in der zweiten Richtung ist;
eine erste Isolierschicht (5A), die auf einer oberen Oberfläche der Basishalbleiterschicht und einer oberen Oberfläche des Abschirmabschnitts bereitgestellt ist; und
mindestens einen lichtemittierenden Abschnitt (4), der auf einer Seitenoberfläche des Körperabschnitts bereitgestellt ist.

2. Lichtemittierende Vorrichtung nach Anspruch 1, wobei die Breite des Abschirmabschnitts in der zweiten Richtung allmählich von der unteren Oberfläche des Abschirmabschnitts in Richtung eines oberen Endes des Abschirmabschnitts in der ersten Richtung abnimmt.

3. Lichtemittierende Vorrichtung nach Anspruch 1 oder 2, wobei die Seitenoberfläche des Körperabschnitts eine unpolare Ebene ist.

4. Lichtemittierende Vorrichtung nach einem vorhergehenden Anspruch, wobei die Seitenoberfläche des Körperabschnitts einen ersten Abschnitt (51) benachbart zu der Basishalbleiterschicht und einen zweiten Abschnitt (52) über dem ersten Abschnitt in der ersten Richtung umfasst,
wobei die lichtemittierende Vorrichtung ferner eine zweite Isolierschicht (5B) umfasst, die auf dem ersten Abschnitt der Seitenoberfläche des Körperabschnitts bereitgestellt ist, der benachbart zu der Basishalbleiterschicht liegt,
wobei der mindestens eine lichtemittierende Abschnitt auf dem zweiten Abschnitt der Seitenoberfläche des Körperabschnitts bereitgestellt ist, der über dem ersten Abschnitt der Seitenoberfläche des Körperabschnitts liegt, und
wobei die zweite Isolierschicht nicht auf dem zweiten Abschnitt der Seitenoberfläche des Körperabschnitts ausgebildet ist.

5. Lichtemittierende Vorrichtung nach einem vorhergehenden Anspruch, wobei die Basishalbleiterschicht ein Material umfasst, das das gleiche wie ein Material des mindestens einen Kerns ist.

6. Lichtemittierende Vorrichtung nach einem vorhergehenden Anspruch, wobei der mindestens eine lichtemittierende Abschnitt Folgendes umfasst:
eine Halbleiterschicht (41) eines ersten Leitfähigkeitstyps, die auf der Seitenoberfläche des Körperabschnitts bereitgestellt ist;
eine aktive Schicht (42), die eine Quantentopfstruktur umfasst und auf der Halbleiterschicht des ersten Leitfähigkeitstyps bereitgestellt ist; und
eine Halbleiterschicht (43) eines zweiten Leitfähigkeitstyps, die auf der aktiven Schicht bereitgestellt ist,
und wobei optional die Basishalbleiterschicht und der mindestens eine Kern ein Material umfassen, das das gleiche wie ein Material der Halbleiterschicht des ersten Leitfähigkeitstyps ist.

7. Lichtemittierende Vorrichtung nach einem vorhergehenden Anspruch, wobei die Basishalbleiterschicht, der mindestens eine Kern und der mindestens eine lichtemittierende Abschnitt ein Halbleitermaterial auf GaN-Basis umfassen.

8. Lichtemittierende Vorrichtung nach einem vorhergehenden Anspruch, wobei der mindestens eine Kern eine Vielzahl von Kernen umfasst, wobei die Vielzahl von Kernen Körperabschnitte mit unterschiedlichen Breiten in der zweiten Richtung umfasst, und
wobei der mindestens eine lichtemittierende Abschnitt eine Vielzahl von lichtemittierenden Abschnitten umfasst, die jeweils auf der Vielzahl von Kernen bereitgestellt sind, und wobei optional die Vielzahl von lichtemittierenden Abschnitten unterschiedliche Höhen in der ersten Richtung aufweist.

9. Lichtemittierende Vorrichtung nach Anspruch 8, wobei die Vielzahl von lichtemittierenden Abschnitten unterschiedliche Breiten in der zweiten Richtung aufweist.

10. Lichtemittierende Vorrichtung nach Anspruch 8 oder 9, wobei jede Seitenoberfläche jedes Körperabschnitts der Vielzahl von Kernen einen ersten Abschnitt benachbart zu der Basishalbleiterschicht und einen zweiten Abschnitt über dem ersten Abschnitt in der ersten Richtung umfasst,
wobei die lichtemittierende Vorrichtung ferner eine Vielzahl von zweiten Isolierschichten umfasst, die jeweils auf den ersten Abschnitten der Seitenoberflächen der Körperabschnitte der Vielzahl von Kernen bereitgestellt ist, die benachbart zu der Basishalbleiterschicht liegen, und
wobei die Vielzahl von zweiten Isolierschichten unterschiedliche Höhen in der ersten Richtung aufweist.

11. Lichtemittierende Vorrichtung nach Anspruch 8, 9 oder 10, wobei die Vielzahl von lichtemittierenden Abschnitten dazu konfiguriert ist, Licht unterschiedlicher Farben zu emittieren.

12. Lichtemittierende Vorrichtung nach einem der Ansprüche 8 bis 11, wobei jeder der Vielzahl von lichtemittierenden Abschnitten unterschiedliche Indiumgehalte umfasst.

13. Anzeige, umfassend:
eine Anzeigetafel, umfassend:
eine lichtemittierende Struktur, umfassend eine Vielzahl von lichtemittierenden Vorrichtungen gemäß einem vorhergehenden Anspruch; und
eine Treiberschaltung, die dazu konfiguriert ist, die lichtemittierende Struktur ein- und auszuschalten; und
eine Steuereinrichtung, die dazu konfiguriert ist, Ein-Aus-Schaltsignale für die Vielzahl von lichtemittierenden Vorrichtungen basierend auf einem Bildsignal in die Treiberschaltung einzugeben.

14. Verfahren zur Herstellung einer lichtemittierenden Vorrichtung, wobei das Verfahren Folgendes umfasst:
Ausbilden einer Basishalbleiterschicht (2) auf einem Substrat (1);
Ausbilden einer Maskenschicht (6), die mindestens ein Wachstumsloch in der Basishalbleiterschicht definiert;
Ausbilden mindestens eines Kerns, umfassend:
einen Körperabschnitt (31), der das mindestens eine Wachstumsloch mindestens teilweise ausfüllt und sich in einer ersten Richtung erstreckt; und
einen Abschirmabschnitt (32), der sich von dem Körperabschnitt über eine obere Oberfläche der Maskenschicht erstreckt, wobei eine Breite einer unteren Oberfläche des Abschirmabschnitts in einer zweiten Richtung orthogonal zu der ersten Richtung größer als eine Breite des Körperabschnitts in der zweiten Richtung ist;
Entfernen der Maskenschicht;
Ausbilden einer ersten Isolierschicht (5a) auf einer oberen Oberfläche der Basishalbleiterschicht und einer oberen Oberfläche des Abschirmabschnitts; und
Ausbilden mindestens eines lichtemittierenden Abschnitts (4) auf einer Seitenoberfläche des Körperabschnitts.

15. Verfahren nach Anspruch 14, wobei das mindestens eine Wachstumsloch eine Vielzahl von Wachstumslöchern mit unterschiedlichen Größen umfasst,
wobei der mindestens eine Kern eine Vielzahl von Kernen umfasst,
wobei der mindestens eine lichtemittierende Abschnitt eine Vielzahl von lichtemittierenden Abschnitten umfasst,
wobei die mindestens eine zweite Isolierschicht eine Vielzahl von zweiten Isolierschichten umfasst,
wobei die Vielzahl von Kernen Körperabschnitte mit unterschiedlichen Breiten in der zweiten Richtung umfasst, die jeweils in der Vielzahl von Wachstumslöchern ausgebildet sind,
wobei die Vielzahl von zweiten Isolierschichten unterschiedliche Höhen in der ersten Richtung aufweist, wobei die Vielzahl von zweiten Isolierschichten jeweils der Vielzahl von Kernen entspricht, und
wobei die Vielzahl von lichtemittierenden Abschnitten auf Abschnitten von Seitenoberflächen von Körperabschnitten jedes der Vielzahl von Kernen ausgebildet ist, in denen jeweilige zweite Isolierschichten der Vielzahl von zweiten Isolierschichten nicht ausgebildet sind.

## Revendications

1. Dispositif électroluminescent (10) comprenant :
une couche semi-conductrice de base (2) ;
au moins un noyau (3) prévu sur la couche semi-conductrice de base, l'au moins un noyau comprenant :
une partie de corps (31) s'étendant dans une première direction ; et
une partie de blindage (32) prévue à une extrémité supérieure de la partie de corps, dans lequel
une largeur d'une surface inférieure de la partie de blindage dans une seconde direction orthogonale à la première direction est supérieure à une largeur de la partie de corps dans la seconde direction ;
une première couche isolante (5A) disposée sur une surface supérieure de la couche semi-conductrice de base et une surface supérieure de la partie de blindage ; et
au moins une partie électroluminescente (4) prévue sur une surface latérale de la partie de corps.

2. Dispositif électroluminescent de la revendication 1, dans lequel la largeur de la partie de blindage dans la seconde direction diminue progressivement depuis la surface inférieure de la partie de blindage vers une extrémité supérieure de la partie de blindage dans la première direction.

3. Dispositif électroluminescent de la revendication 1 ou 2, dans lequel la surface latérale de la partie de corps est un plan non polaire.

4. Dispositif électroluminescent d'une quelconque revendication précédente, dans lequel la surface latérale de la partie de corps comprend une première partie (51) adjacente à la couche semi-conductrice de base et une seconde partie (52) au-dessus de la première partie dans la première direction
dans lequel le dispositif électroluminescent comprend en outre une seconde couche isolante (5B) prévue sur la première partie de la surface latérale de la partie de corps qui est adjacente à la couche semi-conductrice de base,
dans lequel l'au moins une partie électroluminescente est prévue sur la seconde partie de la surface latérale de la partie de corps qui est au-dessus de la première partie de la surface latérale de la partie de corps, et
dans lequel la seconde couche isolante n'est pas formée sur la seconde partie de la surface latérale de la partie de corps.

5. Dispositif électroluminescent d'une quelconque revendication précédente, dans lequel la couche semi-conductrice de base comprend un matériau qui est le même qu'un matériau dudit au moins un noyau.

6. Dispositif électroluminescent d'une quelconque revendication précédente, dans lequel l'au moins une partie électroluminescente comprend :
une couche semi-conductrice d'un premier type de conductivité (41) prévue sur la surface latérale de la partie de corps ;
une couche active (42) comprenant une structure à puits quantique et prévue sur la couche semi-conductrice d'un premier type de conductivité ; et
une couche semi-conductrice d'un second type de conductivité (43) prévue sur la couche active,
et éventuellement dans lequel la couche semi-conductrice de base et l'au moins un noyau comprennent un matériau qui est le même qu'un matériau de la couche semi-conductrice d'un premier type de conductivité.

7. Dispositif électroluminescent d'une quelconque revendication précédente, dans lequel la couche semi-conductrice de base, l'au moins un noyau et l'au moins une partie électroluminescente comprennent un matériau semi-conducteur à base de GaN.

8. Dispositif électroluminescent d'une quelconque revendication précédente, dans lequel l'au moins un noyau comprend une pluralité de noyaux, la pluralité de noyaux comprenant des parties de corps de différentes largeurs dans la seconde direction, et
dans lequel l'au moins une partie électroluminescente comprend une pluralité de parties électroluminescentes respectivement prévues sur la pluralité de noyaux, et éventuellement dans lequel la pluralité de parties électroluminescentes présentent des hauteurs différentes dans la première direction.

9. Dispositif électroluminescent de la revendication 8, dans lequel la pluralité de parties électroluminescentes présentent des largeurs différentes dans la seconde direction.

10. Dispositif électroluminescent de la revendication 8 ou 9, dans lequel chaque surface latérale de chaque partie de corps de la pluralité de noyaux comprend une première partie adjacente à la couche semi-conductrice de base et une seconde partie au-dessus de la première partie dans la première direction,
dans lequel le dispositif électroluminescent comprend en outre une pluralité de secondes couches isolantes respectivement prévues sur les premières parties des surfaces latérales des parties de corps de la pluralité de noyaux qui sont adjacentes à la couche semi-conductrice de base, et
dans lequel la pluralité de secondes couches isolantes présentent des hauteurs différentes dans la première direction.

11. Dispositif électroluminescent de la revendication 8, 9 ou 10, dans lequel la pluralité de parties d'émission de lumière sont configurées pour émettre de la lumière de différentes couleurs.

12. Dispositif électroluminescent de l'une quelconque des revendications 8 à 11, dans lequel chacune de la pluralité de parties électroluminescentes comprend différentes teneurs en indium.

13. Affichage comprenant :
un panneau d'affichage, comprenant :
une structure électroluminescente comprenant une pluralité de dispositifs électroluminescents selon une quelconque revendication précédente ; et
un circuit de pilotage configuré pour allumer et éteindre la structure électroluminescente ; et
un dispositif de commande configuré pour saisir des signaux d'allumage et d'extinction pour la pluralité de dispositifs d'éclairage dans le circuit de commande sur la base d'un signal d'image.

14. Procédé de fabrication d'un dispositif électroluminescent, le procédé comprenant :
la formation d'une couche semi-conductrice de base (2) sur un substrat (1) ;
la formation d'une couche de masque (6) définissant au moins un trou de croissance dans la couche semi-conductrice de base ;
la formation d'au moins un noyau comprenant :
une partie de corps (31) qui remplit au moins partiellement l'au moins un trou de croissance et s'étend dans une première direction ; et
une partie de blindage (32) qui s'étend depuis la partie de corps au-dessus d'une surface supérieure de la couche de masque, dans lequel une largeur d'une surface inférieure de la partie de blindage dans une seconde direction orthogonale à la première direction est supérieure à une largeur de la partie de corps dans la seconde direction ;
le retrait de la couche de masque ;
la formation d'une première couche isolante (5a) sur une surface supérieure de la couche semi-conductrice de base et une surface supérieure de la partie de blindage ; et
la formation d'au moins une partie électroluminescente (4) sur une surface latérale de la partie de corps.

15. Procédé de la revendication 14, dans lequel au moins un trou de croissance comprend une pluralité de trous de croissance présentant différentes tailles,
dans lequel l'au moins un noyau comprend une pluralité de noyaux,
dans lequel l'au moins une partie électroluminescente comprend une pluralité de parties électroluminescentes,
dans lequel l'au moins une seconde couche isolante comprend une pluralité de secondes couches isolantes,
dans lequel la pluralité de noyaux comprend des parties de corps de différentes largeurs dans la seconde direction qui sont formées dans la pluralité de trous de croissance, respectivement,
dans lequel la pluralité de secondes couches isolantes présentent des hauteurs différentes dans la première direction, la pluralité de secondes couches isolantes correspondant respectivement à la pluralité de noyaux, et
dans lequel la pluralité de parties électroluminescentes sont formées sur des parties de surfaces latérales de parties de corps de chacune de la pluralité de noyaux où des secondes couches isolantes respectives de la pluralité de secondes couches isolantes ne sont pas formées.
